# EUROPEAN PATENT APPLICATION

(11) **EP 4 580 339 A1**
(43) Date of publication of application: **02.07.2025**
(21) Application number: 24195963.4
(22) Date of filing: 22.08.2024
(51) Int. Cl.: H10D 64/23, H10D 64/27, H10D 30/00, H10D 30/67, H10D 30/01

(54) **SEMICONDUCTOR DEVICE**

(30) Priority: 29.12.2023 KR 20230196304
(71) Applicant: Samsung Electronics Co., Ltd, Suwon-si, Gyeonggi-do 16677 (KR)
(72) Inventor: LEE, Jin Woo, 16677 Suwon-si (KR); QIAN, Yubo, 16677 Suwon-si (KR); KIM, Su Tae, 16677 Suwon-si (KR)
(74) Representative: Marks & Clerk LLP

(57) **Abstract**

A semiconductor device comprising a first lower interlayer insulating layer, an insulating pattern extending in a first horizontal direction, a first and second plurality of nanosheets stacked apart from one another in a vertical direction, a first gate electrode extending in a second horizontal direction, the first gate electrode surrounding the first plurality of nanosheets, a second gate electrode extending in the second horizontal direction, the second gate electrode surrounding the second plurality of nanosheets, a source/drain region between the first and second gate electrodes, a source/drain contact penetrating the first lower interlayer insulating layer and the insulating pattern, the source/drain contact electrically connected to the source/drain region, and a gate contact penetrating the first lower interlayer insulating layer and the insulating pattern, the gate contact electrically connected to the second gate electrode, at least a portion of a sidewall of the gate contact contacting the source/drain contact.

## Description

### BACKGROUND

Various example embodiments relate to a semiconductor device, and more particularly, to a semiconductor device including a multi-bridge channel field-effect transistor (MBCFET^{™}).

As a scaling technique for increasing the density of integrated circuit devices, the concept of a multi-gate transistor has been proposed in which a silicon body in the form of a fin or nanowire is formed on a substrate and a gate is formed on the surface of the silicon body.

The multi-gate transistor takes advantage of a three-dimensional (3D) channel, allowing for easy scaling both up and down. Additionally, the multi-gate transistor offers improved control over the current without the need to increase the gate length. Furthermore, the multi-gate transistor effectively mitigates the short channel effect (SCE), which is the phenomenon where the electric potential of a channel region is affected by the drain voltage.

### SUMMARY

Various example embodiments provide a semiconductor device capable of securing a process margin for forming a gate contact, a source/drain contact, and a bottom via, which are disposed in a backside region, and simplifying processes for forming a gate contact, a source/drain contact, and a bottom via.

However, various example embodiments of the inventive concepts are not restricted to those set forth herein. The above and other various example embodiments of the inventive concepts will become more apparent to one of ordinary skill in the art to which the present disclosure pertains by referencing the detailed description of various example embodiments given below.

According to various example embodiments of the inventive concepts, there is provided a semiconductor device comprising a first lower interlayer insulating layer, an insulating pattern extending in a first horizontal direction on an upper surface of the first lower interlayer insulating layer, a first plurality of nanosheets stacked apart from one another in a vertical direction on the insulating pattern, a second plurality of nanosheets stacked apart from one another in the vertical direction on the insulating pattern, the second plurality of nanosheets spaced apart from the first plurality of nanosheets in the first horizontal direction, a first gate electrode extending in a second horizontal direction different from the first horizontal direction on the insulating pattern, the first gate electrode surrounding the first plurality of nanosheets, a second gate electrode extending in the second horizontal direction on the insulating pattern, the second gate electrode surrounding the second plurality of nanosheets, the second gate electrode spaced apart from the first gate electrode in the first horizontal direction, a source/drain region between the first and second gate electrodes on the insulating pattern, a source/drain contact penetrating the first lower interlayer insulating layer and the insulating pattern in the vertical direction, the source/drain contact electrically connected to the source/drain region, and a gate contact penetrating the first lower interlayer insulating layer and the insulating pattern in the vertical direction, the gate contact electrically connected to the second gate electrode, at least a portion of a sidewall of the gate contact contacting the source/drain contact. The source/drain contact and the gate contact are integrally formed.

The source/drain region may comprise semiconductor material. Each of the plurality of nanosheets may comprise semiconductor material.

The semiconductor device may comprise at least one multi-gate transistor formed from the nanosheets, gate electrodes and source/drain region.

The insulating pattern may be integrally formed with the first lower interlayer insulating layer. The insulating pattern may correspond to parts of the first lower interlayer insulating layer that protrude in the vertical direction above a horizontal plane in the first lower interlayer insulating layer.

In some embodiments, the semiconductor device further comprises: a second lower interlayer insulating layer on a bottom surface of the first lower interlayer insulating layer; and a bottom via in the second lower interlayer insulating layer, the bottom via contacting each of a bottom surface of the source/drain contact and a bottom surface of the gate contact. The bottom via is in the second lower interlayer insulating layer, i.e. the bottom via is spaced apart in the horizontal direction from the insulating material of the second lower interlayer insulating layer, whilst a top surface of the bottom via is co-planar with a top surface of the second lower interlayer insulating layer.

According to various example embodiments of the inventive concepts , there is provided a semiconductor device comprising a first lower interlayer insulating layer, an insulating pattern extending in a first horizontal direction on an upper surface of the first lower interlayer insulating layer, a plurality of nanosheets stacked apart from one another in a vertical direction on the insulating pattern, a gate electrode extending in a second horizontal direction different from the first horizontal direction on the insulating pattern, the gate electrode surrounding the plurality of nanosheets, a source/drain region on at least one side of the gate electrode on the insulating pattern, a source/drain contact penetrating the first lower interlayer insulating layer and the insulating pattern in the vertical direction, the source/drain contact electrically connected to the source/drain region, a gate contact penetrating the first lower interlayer insulating layer and the insulating pattern in the vertical direction, the gate contact electrically connected to the gate electrode, a second lower interlayer insulating layer on a bottom surface of the first lower interlayer insulating layer, and a bottom via in the second lower interlayer insulating layer, the bottom via contacting each of a bottom surface of the source/drain contact and a bottom surface of the gate contact. The bottom via is integrally formed with each of the source/drain contact and the gate contact.

According to various example embodiments of the inventive concepts , there is provided a semiconductor device comprising a first lower interlayer insulating layer, an insulating pattern extending in a first horizontal direction on an upper surface of the first lower interlayer insulating layer, a first plurality of nanosheets stacked apart from one another in a vertical direction on the insulating pattern, a second plurality of nanosheets stacked apart from one another in the vertical direction on the insulating pattern, the second plurality of nanosheets spaced apart from the first plurality of nanosheets in the first horizontal direction, a third plurality of nanosheets stacked apart from one another in the vertical direction on the insulating pattern, the third plurality of nanosheets spaced apart from the second plurality of nanosheets in the first horizontal direction, a first gate electrode extending in a second horizontal direction different from the first horizontal direction on the insulating pattern, the first gate electrode surrounding the first plurality of nanosheets, a second gate electrode extending in the second horizontal direction on the insulating pattern, the second gate electrode surrounding the second plurality of nanosheets, the second gate electrode spaced apart from the first gate electrode in the first horizontal direction, a third gate electrode extending in the second horizontal direction on the insulating pattern, the third gate electrode surrounding the third plurality of nanosheets, the third gate electrode spaced apart from the second gate electrode in the first horizontal direction, a first source/drain region between the first and second gate electrodes on the insulating pattern, a second source/drain region between the second and third gate electrodes on the insulating pattern, an upper interlayer insulating layer covering each of the first and second source/drain regions, a first source/drain contact penetrating the upper interlayer insulating layer in the vertical direction, the first source/drain contact electrically connected to the first source/drain region, a second source/drain contact penetrating the first lower interlayer insulating layer and the insulating pattern in the vertical direction, the second source/drain contact electrically connected to the second source/drain region, and a gate contact penetrating the first lower interlayer insulating layer and the insulating pattern in the vertical direction, the gate contact electrically connected to the second gate electrode, at least a portion of a sidewall of the gate contact is contacting the second source/drain contact. The second source/drain contact and the gate contact are integrally formed.

It should be noted that the effects of various example embodiments of the inventive concepts are not limited to those described above, and other effects of the present disclosure will be apparent from the following description.

At least some of the above and other features of the invention are set out in the claims.

### BRIEF DESCRIPTION OF THE DRAWINGS

The above and other various example embodiments and features of the inventive concepts will become more apparent by describing in detail various example embodiments thereof with reference to the attached drawings, in which:
FIG. 1 is a layout view for explaining a semiconductor device according to some example embodiments of the inventive concepts;
FIG. 2 is a cross-sectional view taken along line A-A' of FIG. 1;
FIG. 3 is a cross-sectional view taken along line B-B' of FIG. 1;
FIG. 4 is a cross-sectional view taken along line C-C' of FIG. 1;
FIGS. 5 through 41 are cross-sectional views for explaining a method of fabricating a semiconductor device according to some example embodiments of the inventive concepts;
FIGS. 42 through 44 are cross-sectional views for explaining a semiconductor device according to some example embodiments of the inventive concepts;
FIGS. 45 through 47 are cross-sectional views for explaining a semiconductor device according to some example embodiments of the inventive concepts;
FIGS. 48 through 50 are cross-sectional views for explaining a semiconductor device according to some example embodiments of the inventive concepts;
FIG. 51 is a cross-sectional view for explaining a semiconductor device according to some example embodiments of the inventive concepts;
FIG. 52 is a cross-sectional view for explaining a semiconductor device according to some example embodiments of the inventive concepts; and
FIG. 53 is a cross-sectional view for explaining a semiconductor device according to some example embodiments of the inventive concepts.

### DETAILED DESCRIPTION

Semiconductor devices according to some example embodiments of the inventive concepts are illustrated in the accompanying drawings as including multi-bridge channel field-effect transistors (MBCFETs^{™}) with nanosheets, but the present disclosure is not limited thereto. In other example embodiments, the semiconductor devices according to some example embodiments of the inventive concepts may include fin-type field-effect transistors (FinFETs) with fin-shaped pattern channel regions, tunneling field-effect transistors (FETs), or three-dimensional (3D) transistors. Furthermore, in yet other example embodiments, the semiconductor devices according to some example embodiments of the inventive concepts may include bipolar junction transistors or lateral double-diffused metal-oxide semiconductor (LDMOS) transistors.

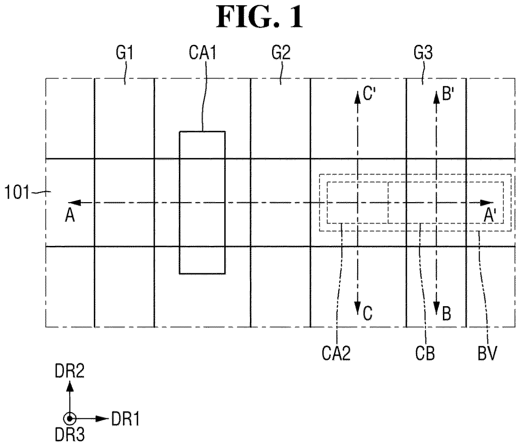

A semiconductor device according to some example embodiments of the inventive concepts will hereinafter be described with reference to FIGS. 1 through 4.

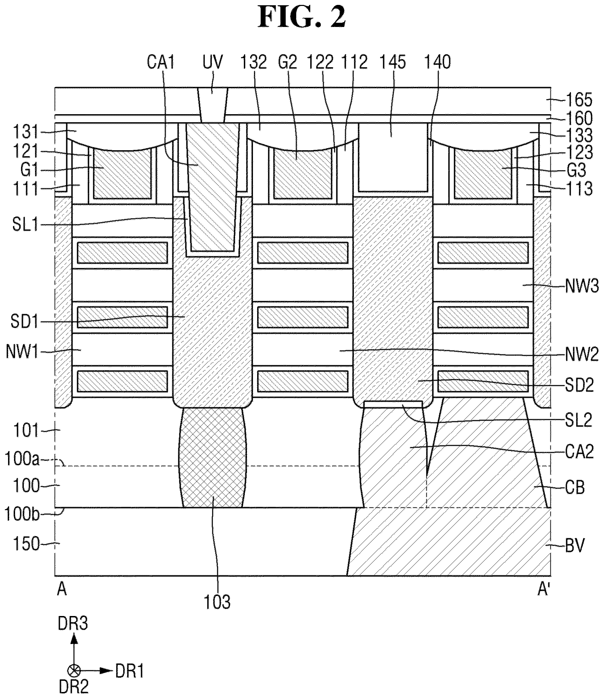

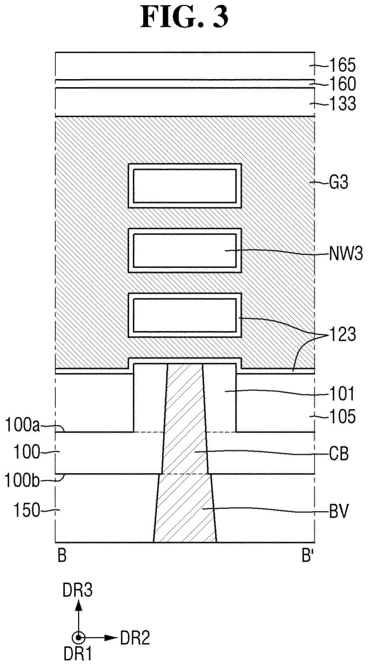

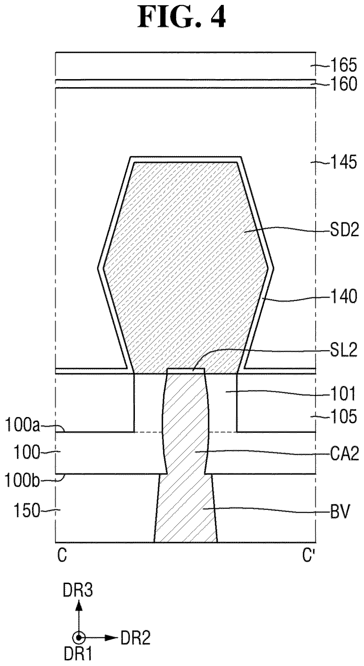

FIG. 1 is a layout view of a semiconductor device according to some example embodiments of the inventive concepts. FIG. 2 is a cross-sectional view taken along line A-A' of FIG. 1. FIG. 3 is a cross-sectional view taken along line B-B' of FIG. 1. FIG. 4 is a cross-sectional view taken along line C-C' of FIG. 1.

Referring to FIGS. 1 through 4, the semiconductor device according to some example embodiments of the inventive concepts includes a first lower interlayer insulating layer 100, an insulating pattern 101, a first sacrificial pattern 103, a field insulating layer 105, a first plurality of nanosheets NW1, a second plurality of nanosheets NW2, a third plurality of nanosheets NW3, first, second, and third gate electrodes G1, G2, and G3, first gate spacers 111, second gate spacers 112, and third gate spacers 113, first, second, and third gate insulating layers 121, 122, and 123, first, second, and third capping patterns 131, 132, and 133, first and second source/drain regions SD1 and SD2, a first etch stopping layer 140, a first upper interlayer insulating layer 145, a second lower interlayer insulating layer 150, first and second source/drain contacts CA1 and CA2, first and second silicide layers SL1 and SL2, a gate contact CB, a bottom via BV, a second etch stopping layer 160, a second upper interlayer insulating layer 165, and an upper via UV.

The first lower interlayer insulating layer 100 may include at least one of, for example, silicon oxide, silicon nitride, silicon oxynitride, and a low-k material. The low-k material may be formed from a semiconductor manufacturing process such as, for example, fluorinated tetraethyl orthosilicate (FTEOS), hydrogen silsesquioxane (HSQ), bis-benzocyclobutene (BCB), tetramethyl orthosilicate (TMOS), octamethylcyclotetrasiloxane (OMCTS), hexamethyldisiloxane (HMDS), trimethylsilyl borate (TMSB), diacetoxy ditertiary butoxy siloxane (DADBS), trimethylsilil phosphate (TMSP), polytetrafluoroethylene (PTFE), tonen silazen (TOSZ), fluoride silicate glass (FSG), polyimide nanofoam such as polypropylene oxide, carbon doped silicon oxide (CDO), organo silicate glass (OSG), SiLK, amorphous fluorinated carbon, silica aerogel, silica xerogel, mesoporous silica, or a combination thereof, but example embodiments are not limited thereto.

First and second horizontal directions DR1 and DR2 may be defined as directions parallel to an upper surface 100a of the first lower interlayer insulating layer 100. The second horizontal direction DR2 may be defined as a different direction from the first horizontal direction DR1. The second horizontal direction DR2 may be perpendicular to the first horizontal direction DR1. A vertical direction DR3 is defined as a direction perpendicular to both the first and second horizontal directions DR1 and DR2. That is, the vertical direction DR3 is defined as a direction perpendicular to the upper surface 100a of the first lower interlayer insulating layer 100.

The insulating pattern 101 may extend in the first horizontal direction DR1 on the upper surface 100a of the first lower interlayer insulating layer 100. The insulating pattern 101 may protrude in the vertical direction DR3 from the upper surface 100a of the first lower interlayer insulating layer 100. The insulating pattern 101 may include an insulating material. For example, the insulating pattern 101 may include the same material as the first lower interlayer insulating layer 100.

The field insulating layer 105 may be disposed on the upper surface 100a of the first lower interlayer insulating layer 100. The field insulating layer 105 may surround the sidewalls of the insulating pattern 101. For example, the upper surface of the insulating pattern 101 may protrude in the vertical direction DR3 beyond the upper surface of the field insulating layer 105, but example embodiments are not limited thereto. In other example embodiments, the upper surface of the insulating pattern 101 may be formed on the same plane as the upper surface of the field insulating layer 105. The field insulating layer 105 may include, for example, an oxide film, a nitride film, an oxynitride film, or a combination thereof.

The first plurality of nanosheets NW1 may be disposed on the insulating pattern 101. The first plurality of nanosheets NW1 may be disposed at the intersection of the insulating pattern 101 and the first gate electrode G1. The second plurality of nanosheets NW2 may be disposed on the insulating pattern 101. The second plurality of nanosheets NW2 may be disposed at the intersection of the insulating pattern 101 and the second gate electrode G2. The second plurality of nanosheets NW2 may be spaced apart from the first plurality of nanosheets NW1 in a first horizontal direction DR1. The third plurality of nanosheets NW3 may be disposed on the insulating pattern 101. The third plurality of nanosheets NW3 may be disposed at the intersection of the insulating pattern 101 and the third gate electrode G3. The third plurality of nanosheets NW3 may be spaced apart from the second plurality of nanosheets NW2 in the first horizontal direction DR1.

The first plurality of nanosheets NW1, the second plurality of nanosheets NW2, and the third plurality of nanosheets NW3 may include stacks of nanosheets that are spaced apart from one another in a vertical direction DR3. In FIGS. 2 and 3, the first plurality of nanosheets NW1, the second plurality of nanosheets NW2, and the third plurality of nanosheets NW3 are illustrated as including stacks of three nanosheets that are spaced apart from one another in the vertical direction DR3, but example embodiments are not limited thereto. Alternatively, in some example embodiments, the first plurality of nanosheets NW1, the second plurality of nanosheets NW2, and the third plurality of nanosheets NW3 may include stacks of more than four nanosheets that are spaced apart from one another in the vertical direction DR3. For example, the first plurality of nanosheets NW1, the second plurality of nanosheets NW2, and the third plurality of nanosheets NW3 may include silicon (Si), but example embodiments are not limited thereto. Alternatively, in some example embodiments, the first plurality of nanosheets NW1, the second plurality of nanosheets NW2, and the third plurality of nanosheets NW3 may include silicon-germanium (SiGe).

The first gate electrode G1 may extend in a second horizontal direction DR2 on both the insulating pattern 101 and the field insulating layer 105. The first gate electrode G1 may surround the first plurality of nanosheets NW1. The second gate electrode G2 may extend in the second horizontal direction DR2 on both the insulating pattern 101 and the field insulating layer 105. The second gate electrode G2 may surround the second plurality of nanosheets NW2. The second gate electrode G2 may be spaced apart from the first gate electrode G1 in the first horizontal direction DR1. The third gate electrode G3 may extend in the second horizontal direction DR2 on both the insulating pattern 101 and the field insulating layer 105. The third gate electrode G3 may surround the third plurality of nanosheets NW3. The third gate electrode G3 may be spaced apart from the second gate electrode G2 in the first horizontal direction DR1.

The first, second, and third gate electrode G1, G2, and G3 may include, for example, titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAlN), tantalum aluminum nitride (TaAIN), tungsten nitride (WN), ruthenium (Ru), titanium aluminum (TiAl), titanium aluminum carbonitride (TiAlC-N), titanium aluminum carbide (TiAlC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt), nickel-platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), or a combination thereof. However, example embodiments are not limited thereto. The first, second, and third gate electrode G1, G2, and G3 may include a conductive metal oxide or conductive metal oxynitride, and may also include an oxidized form of any one of the aforementioned materials.

The first gate spacers 111 may extend in the second horizontal direction DR2 along both sidewalls of the first gate electrode G1 on both the upper surface of the upper first nanosheet NW1 and the field insulating layer 105. The second gate spacers 112 may extend in the second horizontal direction DR2 along both sidewalls of the second gate electrode G2 on both the upper surface of the uppermost nanosheet of the second plurality of nanosheets NW2 and the field insulating layer 105. The third gate spacers 113 may extend in the second horizontal direction DR2 along both sidewalls of the third gate electrode G3 on both the upper surface of the uppermost nanosheet of the third plurality of nanosheets NW3 and the field insulating layer 105.

The first gate spacers 111, the second gate spacers 112, and the third gate spacers 113 may include, for example, at least one of silicon nitride (SiN), silicon oxynitride (SiON), silicon oxide (SiO₂), silicon oxycarbonitride (SiOCN), silicon boron nitride (SiBN), silicon oxyboron nitride (SiOBN), silicon oxycarbide (SiOC), and a combination thereof, but example embodiments are not limited thereto.

The first source/drain region SD1 may be disposed on both sides of the first gate electrode G1 on the insulating pattern 101. For example, the first source/drain region SD1 may be disposed between the first and second gate electrodes G1 and G2 on the insulating pattern 101. The second source/drain region SD2 may be disposed on both sides of the third gate electrode G3 on the insulating pattern 101. For example, the second source/drain region SD2 may be disposed between the second gate electrode G2 and the third gate electrode G3 on the insulating pattern 101.

The first and second source/drain regions SD1 and SD2 may contact the insulating pattern 101. The first source/drain region SD1 may contact the sidewalls, in the first horizontal direction DR1, of both the first plurality of nanosheets NW1 and the second plurality of nanosheets NW2. The second source/drain region SD2 may contact the sidewalls, in the first horizontal direction DR1, of both the second plurality of nanosheets NW2 and the third plurality of nanosheets NW3. For example, the upper surfaces of the first and second source/drain regions SD1 and SD2 may be formed higher than the upper surfaces of the uppermost nanosheets of each of the first, second, and third plurality of nanosheets NW1, NW2, and NW3.

The first sacrificial pattern 103 may penetrate the first lower interlayer insulating layer 100 and the insulating pattern 101 in the vertical direction DR3. For example, the upper surface of the first sacrificial pattern 103 may contact the bottom surface of the first source/drain region SD1. The bottom surface of the first sacrificial pattern 103 may be formed on the same plane as a bottom surface 100b of the first lower interlayer insulating layer 100. The first sacrificial pattern 103 may include a material different from a material of each of the first lower interlayer insulating layer 100 and the insulating pattern 101. For example, the first sacrificial pattern 103 may include SiGe. In other example embodiments, the first sacrificial pattern 103 may include a low-k material different from a low-k material of each of the first lower interlayer insulating layer 100 and the insulating pattern 101.

The first gate insulating layer 121 may be disposed between the first gate electrode G1 and the insulating pattern 101. The first gate insulating layer 121 may also be disposed between the first gate electrode G1 and the field insulating layer 105. The first gate insulating layer 121 may also be disposed between the first gate electrode G1 and the first gate spacers 111. The first gate insulating layer 121 may also be disposed between the first gate electrode G1 and the first plurality of nanosheets NW1. The first gate insulating layer 121 may also be disposed between the first gate electrode G1 and the first source/drain region SD1.

The second gate insulating layer 122 may be disposed between the second gate electrode G2 and the insulating pattern 101. The second gate insulating layer 122 may also be disposed between the second gate electrode G2 and the field insulating layer 105. The second gate insulating layer 122 may also be disposed between the second gate electrode G2 and the second gate spacers 112. The second gate insulating layer 122 may also be disposed between the second gate electrode G2 and the second plurality of nanosheets NW2. The second gate insulating layer 122 may also be disposed between the second gate electrode G2 and the first and second source/drain regions SD1 and SD2.

The third gate insulating layer 123 may be disposed between the third gate electrode G3 and the insulating pattern 101. The third gate insulating layer 123 may also be disposed between the third gate electrode G3 and the field insulating layer 105. The third gate insulating layer 123 may also be disposed between the third gate electrode G3 and the third gate spacers 113. The third gate insulating layer 123 may also be disposed between the third gate electrode G3 and the third plurality of nanosheets NW3. The third gate insulating layer 123 may also be disposed between the third gate electrode G3 and the second source/drain region SD2.

The first, second, and third gate insulating layers 121, 122, and 123 may contact the insulating pattern 101. For example, the first and second gate insulating layers 121 and 122 may contact the first source/drain region SD1, and the second and third gate insulating layers 122 and 123 may contact the second source/drain region SD2. However, example embodiments are not limited to this. Alternatively, in some example embodiments, inner spacers may be disposed between the first source/drain region SD1 the first and second gate insulating layers 121 and 122. Similarly, inner spacers may be disposed between the second source/drain region SD2 and the second and third gate insulating layers 122 and 123. These inner spacers may include, for example, at least one of SiN, SiON, SiO₂, SiOCN, SiBN, SiOBN, SiOC, and a combination thereof. However, example embodiments are not limited thereto.

The first, second, and third gate insulating layers 121, 122, and 123 may include at least one of silicon oxide, silicon oxynitride, silicon nitride, and a high-k material with a greater dielectric constant than silicon oxide. The high-k material may include, for example, at least one of hafnium oxide, hafnium silicon oxide, hafnium aluminum oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. However, example embodiments are not limited thereto.

The semiconductor device according to some example embodiments of the inventive concepts may include negative capacitance (NC) FETs using negative capacitors. For example, each of the first, second, and third gate insulating layers 121, 122, and 123 may include a ferroelectric material film having ferroelectric properties and a paraelectric material film having paraelectric properties.

The ferroelectric material film may have a negative capacitance, and the paraelectric material film may have a positive capacitance. For example, if two or more capacitors are connected in series and have positive capacitance, the total capacitance of the two or more capacitors may be lower than the capacitance of each of the two or more capacitors. On the contrary, if at least one of the two or more capacitors has negative capacitance, the total capacitance of the two or more capacitors may have a positive value and may be greater than the absolute value of the capacitance of each of the two or more capacitors.

If the ferroelectric material film having a negative capacitance and the paraelectric material film having a positive capacitance are connected in series, the total capacitance of the ferroelectric material film and the paraelectric material film may increase. Accordingly, a transistor having the ferroelectric material film can have a sub-threshold swing (SS) of less than 60 mV/decade at room temperature.

The ferroelectric material film may have ferroelectric properties. The ferroelectric material film may include at least one of, for example, hafnium oxide, hafnium zirconium oxide, barium strontium titanium oxide, barium titanium oxide, and lead zirconium titanium oxide. For example, the hafnium zirconium oxide may be a material obtained by doping hafnium oxide with zirconium (Zr). However, example embodiments are not limited thereto. In another example, the hafnium zirconium oxide may be a compound of hafnium (Hf), Zr, and oxygen (O).

The ferroelectric material film may further include a dopant. For example, the dopant may include at least one of Al, Ti, Nb, lanthanum (La), yttrium (Y), magnesium (Mg), Si, calcium (Ca), cerium (Ce), dysprosium (Dy), erbium (Er), gadolinium (Gd), Ge, scandium (Sc), strontium (Sr), and Sn. However, example embodiments are not limited thereto. The type of dopant may vary depending on the type of material of the ferroelectric material film.

If the ferroelectric material film includes hafnium oxide, the dopant of the ferroelectric material film may include at least one of, for example, Gd, Si, Zr, Al, and Y. However, example embodiments are not limited thereto.

If the dopant of the ferroelectric material film is Al, the ferroelectric material film may include about 3 atomic% (at%) to about 8 at% of Al. Here, the ratio of the dopant in the ferroelectric material film may refer to the ratio of the sum of the amounts of Hf and Al to the amount of Al in the ferroelectric material film.

If the dopant of the ferroelectric material film is Si, the ferroelectric material film may include about 2 at% to about 10 at% of Si. If the dopant of the ferroelectric material film is Y, the ferroelectric material film may include about 2 at% to about 10 at% of Y. If the dopant of the ferroelectric material film is Gd, the ferroelectric material film may include about 1 at% to about 7 at% of Gd. If the dopant of the ferroelectric material film is Zr, the ferroelectric material film may include about 50 at% to about 80 at% of Zr.

The paraelectric material film may include paraelectric properties. The paraelectric material film may include at least one of, for example, silicon oxide and a high-k metal oxide. The high-k metal oxide may include at least one of, for example, hafnium oxide, zirconium oxide, and aluminum oxide, but example embodiments are not limited thereto.

The ferroelectric material film and the paraelectric material film may include the same material. The ferroelectric material film may have ferroelectric properties, but the paraelectric material film may not have ferroelectric properties. For example, if the ferroelectric material film and the paraelectric material film include hafnium oxide, the hafnium oxide included in the ferroelectric material film may have a different crystalline structure from the hafnium oxide included in the paraelectric material film.

The ferroelectric material film may be thick enough to exhibit ferroelectric properties. The ferroelectric material film may have a thickness of, for example, about 0.5 nm to about 10 nm, but example embodiments are not limited thereto. A critical thickness that can exhibit ferroelectric properties may vary depending on the type of ferroelectric material, and thus, the thickness of the ferroelectric material film may vary depending on the type of ferroelectric material included in the ferroelectric material film.

For example, each of the first, second, and third gate insulating layers 121, 122, and 123 may include a ferroelectric material film. In another example, each of the first, second, and third gate insulating layers 121, 122, and 123 may include a plurality of ferroelectric material films that are spaced apart from each other. Each of the first, second, and third gate insulating layers 121, 122, and 123 may include a stack of a plurality of ferroelectric material films and a plurality of paraelectric material films that are alternately stacked with the ferroelectric material films.

The first etch stopping layer 140 may be disposed on the sidewalls, in the first horizontal direction DR1, of the first gate spacers 111, the second gate spacers 112, and the third gate spacers 113. The first etch stopping layer 140 may also be disposed on the upper surface of the field insulating layer 105. The first etch stopping layer 140 may also be disposed on the sidewalls, in the second horizontal direction DR2, of the first and second source/drain regions SD1 and SD2. The first etch stopping layer 140 may also be disposed on the upper surfaces of the first and second source/drain regions SD1 and SD2. For example, the first etch stopping layer 140 may be conformally formed. The first etch stopping layer 140 may include, for example, at least one of aluminum oxide, aluminum nitride, hafnium oxide, zirconium oxide, silicon oxide, silicon nitride, silicon oxynitride, and a low-k material. However, example embodiments are not limited thereto.

The first capping pattern 131 may extend in the second horizontal direction DR2 over the first gate spacers 111, the first gate insulating layer 121, and the first gate electrode G1. The second capping pattern 132 may extend in the second horizontal direction DR2 over the second gate spacers 112, the second gate insulating layer 122, and the second gate electrode G2. The third capping pattern 133 may extend in the second horizontal direction DR2 over the third gate spacers 113, the third gate insulating layer 123, and the third gate electrode G3.

For example, the bottom surfaces of each of the first, second, and third capping patterns 131, 132, and 133 may contact the first etch stopping layer 140, but example embodiments are not limited thereto. In other example embodiments, the sidewalls of each of the first, second, and third capping patterns 131, 132, and 133 may also contact the first etch stopping layer 140. The first etch stopping layer 140 may include, for example, at least one of SiN, SiON, SiO₂, SiCN, SiOCN, and a combination thereof, but example embodiments are not limited thereto.

The first upper interlayer insulating layer 145 may be disposed on the first etch stopping layer 140. The first upper interlayer insulating layer 145 may also be disposed on the sidewalls of each of the first, second, and third capping patterns 131, 132, and 133. The first upper interlayer insulating layer 145 may cover the first and second source/drain regions SD1 and SD2 on the field insulating layer 105. For example, the upper surface of the first upper interlayer insulating layer 145 may be formed on the same plane as the upper surfaces of the first, second, and third capping patterns 131, 132, and 133. The first upper interlayer insulating layer 145 may include, for example, at least one of silicon oxide, silicon nitride, silicon oxynitride, and a low-k material.

The first source/drain contact CA1 may be disposed between the first and second gate electrodes G1 and G2. The first source/drain contact CA1 may be disposed above the first source/drain region SD1. The first source/drain contact CA1 may extend into the first source/drain region SD1 by penetrating the first upper interlayer insulating layer 145 and the first etch stopping layer 140 in the vertical direction DR3. The first source/drain contact CA1 may be electrically connected to the first source/drain region SD1. In FIG. 2, the first source/drain contact CA1 is illustrated as being a single layer, but example embodiments are is not limited thereto. Alternatively, in some example embodiments, the first source/drain contact CA1 may be formed as a multilayer.

For example, the upper surface of the first source/drain contact CA1 may be formed on the same plane as the upper surface of the first upper interlayer insulating layer 145, but example embodiments are not limited thereto. Alternatively, in some example embodiments, the upper surface of the first source/drain contact CA1 may be formed higher than the upper surface of the first upper interlayer insulating layer 145. The first source/drain contact CA1 may include a conductive material.

The first silicide layer SL1 may be disposed between the first source/drain contact CA1 and the first source/drain region SD1. The first silicide layer SL1 may be disposed along the boundary between the first source/drain contact CA1 and the first source/drain region SD1. The first silicide layer SL1 may include, for example, a metal silicide material.

The second source/drain contact CA2 may be disposed between the second and third gate electrodes G2 and G3. The second source/drain contact CA2 may be disposed below the second source/drain region SD2. The second source/drain contact CA2 may be connected to the second source/drain region SD2 by penetrating the first lower interlayer insulating layer 100 and the insulating pattern 101 in the vertical direction DR3. The second source/drain contact CA2 may be electrically connected to the second source/drain region SD2. For example, the second source/drain contact CA2 may be formed as a single layer.

For example, the upper surface of the second source/drain contact CA2 may be formed lower than the bottom surface of the lowermost nanosheet of the third plurality of nanosheets NW3. The bottom surface of the second source/drain contact CA2 may be formed on the same plane as the bottom surface 100b of the first lower interlayer insulating layer 100. The second source/drain contact CA2 may include a conductive material. For example, the second source/drain contact CA2 may include one of Al, W, Co, Ru, and Mo. However, example embodiments are not limited thereto.

The second silicide layer SL2 may be disposed between the second source/drain contact CA2 and the second source/drain region SD2. The second silicide layer SL2 may be disposed along the boundary between the second source/drain contact CA2 and the second source/drain region SD2. The second silicide layer SL2 may include, for example, a metal silicide material.

The gate contact CB may be disposed below the third gate electrode G3. The gate contact CB may contact the third gate insulating layer 123 by penetrating the first lower interlayer insulating layer 100 and the insulating pattern 101 in the vertical direction DR3. That is, at least part of the third gate insulating layer 123 may be disposed between the third gate electrode G3 and the gate contact CB. The gate contact CB may be electrically connected to the third gate electrode G3. For example, the gate contact CB may be formed as a single layer.

For example, the upper surface of the gate contact CB may be formed higher than the upper surface of the second source/drain contact CA2. The bottom surface of the gate contact CB may be formed on the same plane as both the bottom surface of the second source/drain contact CA2 and the bottom surface 100b of the first lower interlayer insulating layer 100. At least parts of the sidewalls, in the first horizontal direction DR1, of the gate contact CB may contact the second source/drain contact CA2. At least part of the insulating pattern 101 may be disposed between the gate contact CB and the second source/drain contact CA2. At least part of the insulating pattern 101 between the gate contact CB and the second source/drain contact CA2 may contact both the second source/drain region SD2 and the third gate insulating layer 123.

For example, the gate contact CB and the second source/drain contact CA2 may be integrally formed. The gate contact CB may include the same material as the second source/drain contact CA2. For example, the gate contact CB may include one of Al, W, Co, Ru, and Mo. However, example embodiments are not limited thereto.

The second lower interlayer insulating layer 150 may be disposed on the bottom surface 100b of the first lower interlayer insulating layer 100. The second lower interlayer insulating layer 150 may include, for example, at least one of silicon oxide, silicon nitride, silicon oxynitride, and a low-k material. The second lower interlayer insulating layer 150 may include a material different from a material of the first lower interlayer insulating layer 100, but example embodiments are not limited thereto. Alternatively, in some example embodiments, the second lower interlayer insulating layer 150 may include the same material as the first lower interlayer insulating layer 100.

The bottom via BV may be disposed in the second lower interlayer insulating layer 150. The upper surface of the bottom via BV may contact the bottom surfaces of both the second source/drain contact CA2 and the gate contact CB. That is, the bottom via BV may be connected to both the second source/drain contact CA2 and the gate contact CB. For example, the bottom via BV may be formed as a single layer.

For example, the upper surface of the bottom via BV may be formed on the same plane as the upper surface of the second lower interlayer insulating layer 150. Similarly, the bottom surface of the bottom via BV may be formed on the same plane as the bottom surface of the second lower interlayer insulating layer 150. The bottom via BV, the second source/drain contact CA2, and the gate contact CB may be integrally formed. The bottom via BV may include the same material as the second source/drain contact CA2 and the gate contact CB. For example, the bottom via BV may include one of Al, W, Co, Ru, and Mo. However, example embodiments are not limited thereto.

The second etch stopping layer 160 may be disposed on the upper surfaces of the first source/drain contact CA1, the first, second, and third capping patterns 131, 132, and 133, and the first upper interlayer insulating layer 145. In FIGS. 2 through 4, the second etch stopping layer 160 is illustrated as being a single layer, but example embodiments are not limited thereto. Alternatively, in some example embodiments, the second etch stopping layer 160 may be formed as a multilayer. The second etch stopping layer 160 may include, for example, at least one of aluminum oxide, aluminum nitride, hafnium oxide, zirconium oxide, silicon oxide, silicon nitride, silicon oxynitride, and a low-k material. However, example embodiments are not limited thereto.

The second upper interlayer insulating layer 165 may be disposed on the second etch stopping layer 160. The second upper interlayer insulating layer 165 may include, for example, at least one of silicon oxide, silicon nitride, silicon oxynitride, and a low-k material. However, example embodiments are not limited thereto. The upper via UV may be connected to the first source/drain contact CA1 by penetrating the second upper interlayer insulating layer 165 and the second etch stopping layer 160 in the vertical direction DR3. In FIG. 2, the upper via UV is illustrated as being a single layer, but example embodiments are not limited thereto. Alternatively, in some example embodiments, the upper via UV may be formed as a multilayer. The upper via UV may include a conductive material.

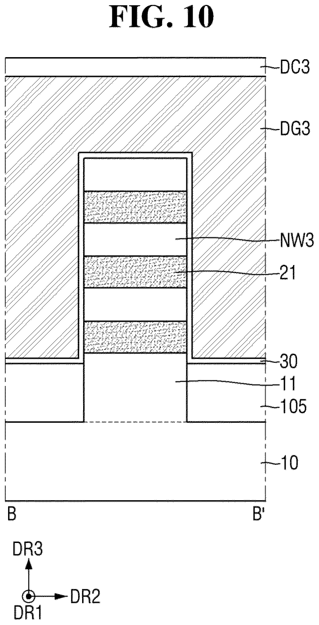

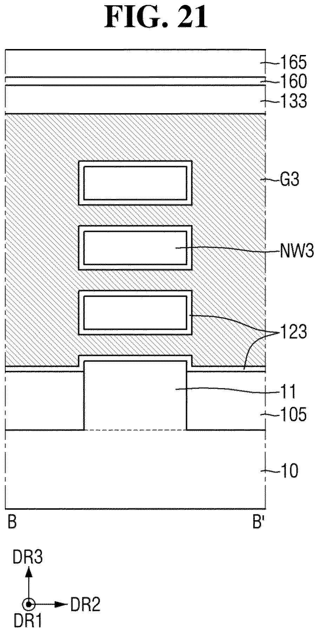

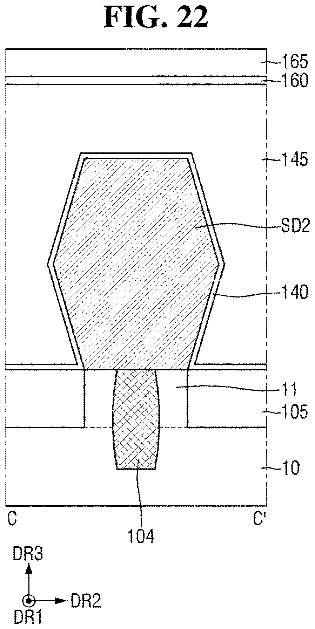

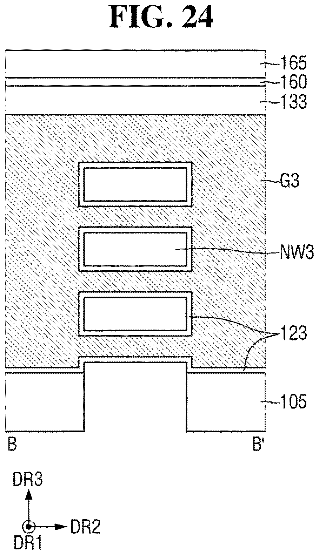

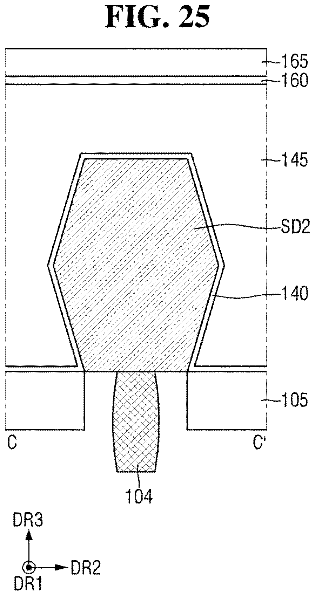

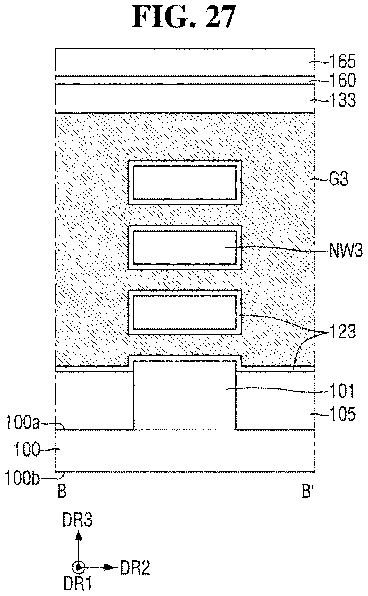

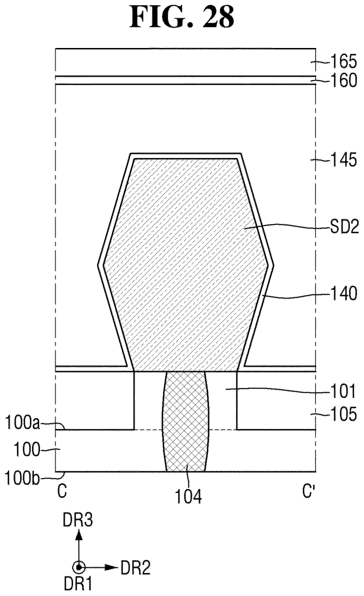

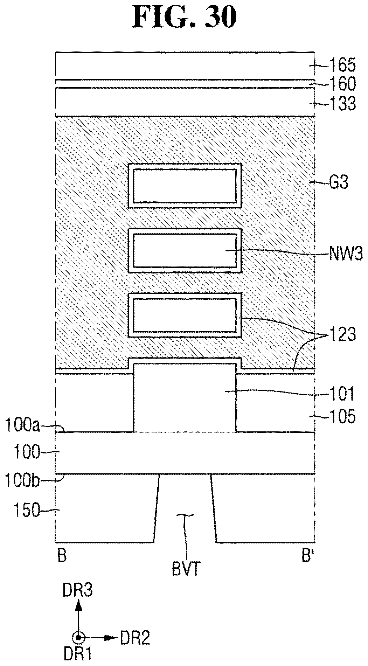

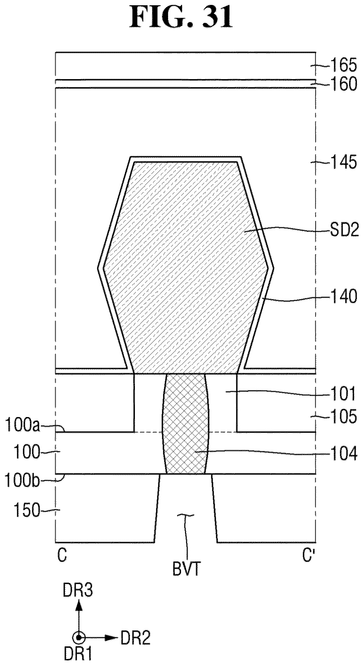

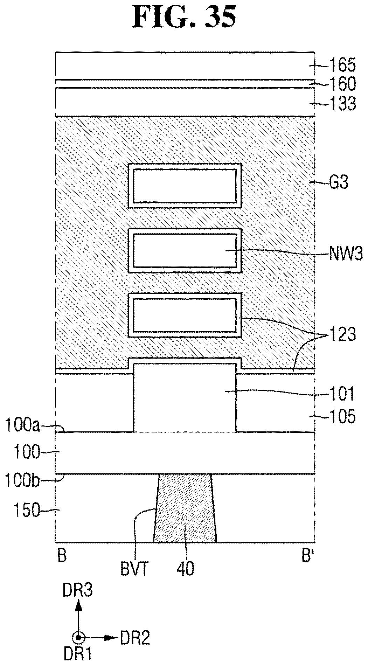

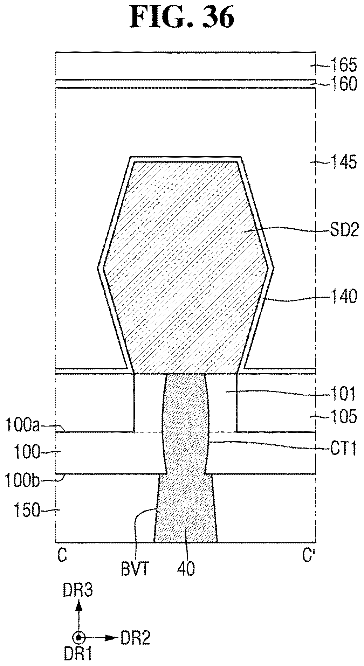

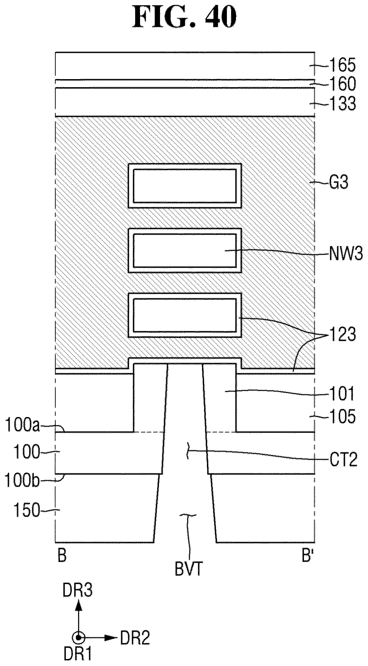

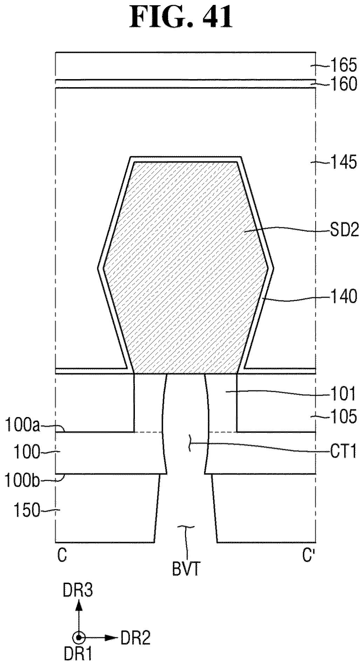

A method of fabricating a semiconductor device according to some example embodiments will hereinafter be described with reference to FIGS. 2 through 41.

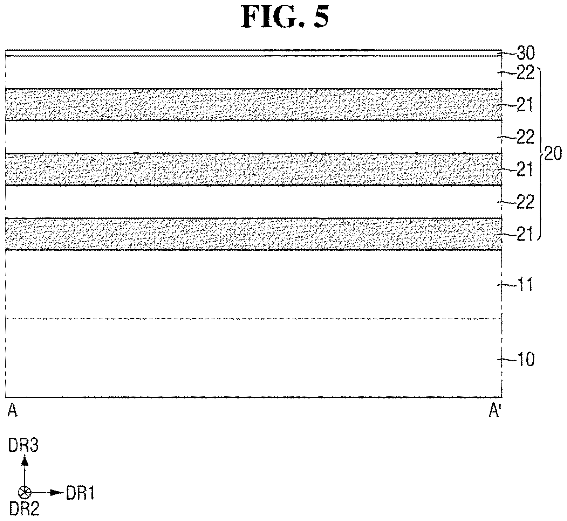

FIGS. 5 through 41 are cross-sectional views for explaining a method of fabricating a semiconductor device according to some example embodiments of the inventive concepts.

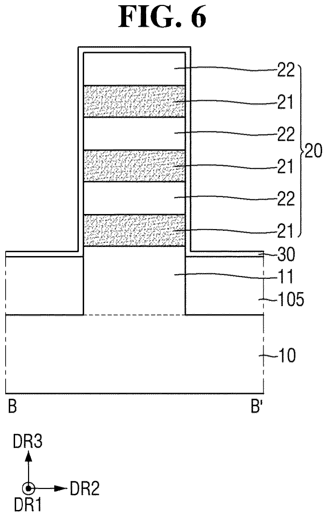

Referring to FIGS. 5 and 6, a substrate 10 may be provided. The substrate 10 may be a Si or silicon-on-insulator (SOI) substrate, but example embodiments are not limited thereto. The substrate 10 may also include a material such as SiGe, SiGe-on-insulator (SGOI), antimonide indium, a lead telluride compound, indium arsenide, indium phosphide, gallium antimonide, or antimonide gallium, but example embodiments are not limited thereto.

Thereafter, a stacked structure 20 may be formed on the upper surface of the substrate 10. The stacked structure 20 may include first semiconductor layers 21 and second semiconductor layers 22, which are stacked on the upper surface of the substrate 10 alternately with the first semiconductor layers 21. For example, one of the first semiconductor layers 21 may be formed at the bottom of the stacked structure 20, and one of the second semiconductor layers 22 may be formed at the top of the stacked structure 20. However, example embodiments are not limited to this example. Alternatively, in some example embodiments, the first semiconductor layers 21 may also be formed at the top of the stacked structure 20. The first semiconductor layers 21 may include, for example, SiGe. The second semiconductor layer 22 may include, for example, Si.

Thereafter, part of the stacked structure 20 may be etched. During the etching of the stacked structure 20, part of the substrate 10 may also be etched. Consequently, an active pattern 11 may be defined below the stacked structure 20, on the upper surface of the substrate 10. The active pattern 11 may protrude in a vertical direction DR3 from the upper surface of the substrate 10. The active pattern 11 may extend in a first horizontal direction DR1.

Thereafter, a field insulating layer 105 may be formed on the upper surface of the substrate 10. The field insulating layer 105 may surround the sidewalls of the active pattern 11. For example, the upper surface of the active pattern 11 may be formed higher than the upper surface of the field insulating layer 105. Thereafter, a pad oxide layer 30 may be formed to cover the upper surface of the field insulating layer 105, the exposed sidewalls of the active pattern 11, and the sidewalls and upper surface of the stacked structure 20. For example, the pad oxide layer 30 may be conformally formed. The pad oxide layer 30 may include, for example, SiO₂.

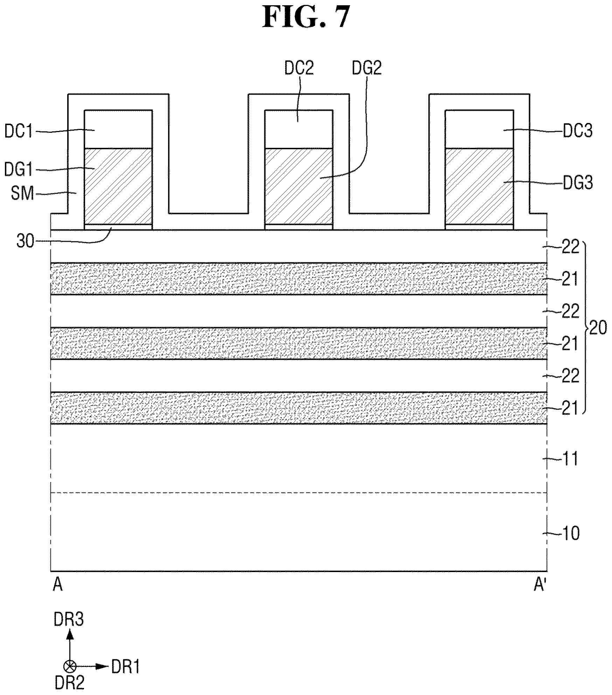

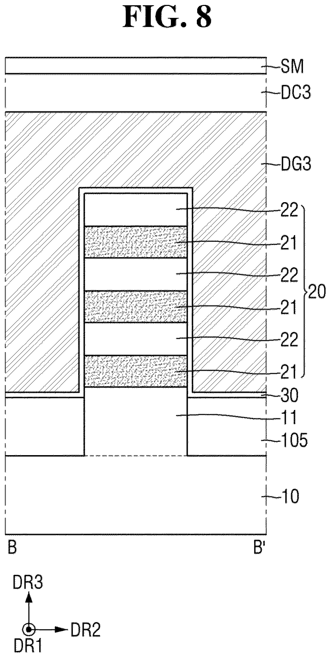

Referring to FIGS. 7 and 8, first, second, and third dummy gates DG1, DG2, and DG3 and first, second, and third dummy capping patterns DC1, DC2, and DC3, which extend in a second horizontal direction DR2, may be formed on the pad oxide layer 30, above both the stacked structure 20 and the field insulating layer 105. Specifically, the second dummy gate DG2 may be spaced apart from the first dummy gate DG1 in the first horizontal direction DR1. The third dummy gate DG3 may be spaced apart from the second dummy gate DG2 in the first horizontal direction DR1. The first dummy capping pattern DC1 may be disposed on the first dummy gate DG1. The second dummy capping pattern DC2 may be disposed on the second dummy gate DG2. The third dummy capping pattern DC3 may be disposed on the third dummy gate DG3.

During the formation of the first, second, and third dummy gates DG1, DG2, and DG3 and the first, second, and third dummy capping patterns DC1, DC2, and DC3, the entire pad oxide layer 30 except for parts overlapping with the first, second, and third dummy gates DG1, DG2, and DG3 in the vertical direction DR3 on the substrate 10 may be removed.

Thereafter, a spacer material layer SM may be formed to cover the sidewalls of each of the first, second, and third dummy gates DG1, DG2, and DG3, the sidewalls and upper surfaces of each of the first, second, and third dummy capping patterns DC1, DC2, and DC3, the exposed sidewalls and upper surface of the stacked structure 20, and the upper surface of the field insulating layer 105. For example, the spacer material layer SM may be conformally formed. The spacer material layer SM may include, for example, at least one of SiN, SiON, SiO₂, SiOCN, SiBN, SiOBN, SiOC, and a combination thereof. However, example embodiments are not limited thereto.

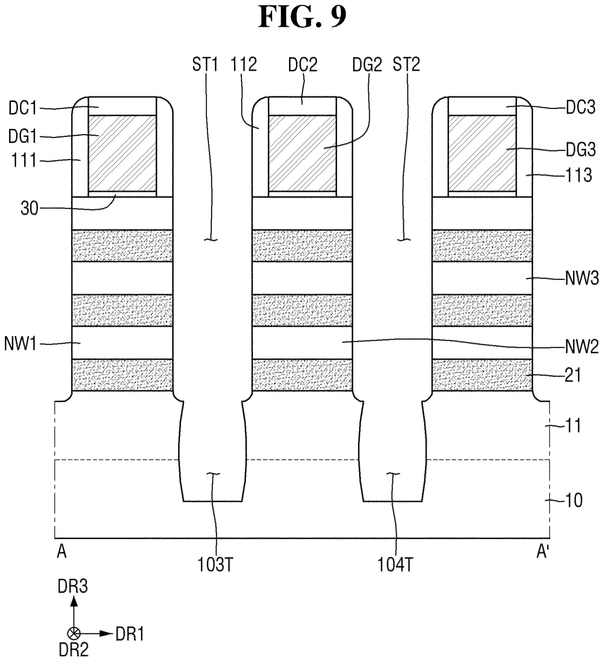

Referring to FIGS. 9 through 11, the stacked structure 20 of FIGS. 7 and 8 may be etched using the first, second, and third dummy gates DG1, DG2, and DG3 and the first, second, and third dummy capping patterns DC1, DC2, and DC3 as a mask, thereby forming first and second source/drain trenches ST1 and ST2. The first source/drain trench ST1 may be formed between the first and second dummy gates DG1 and DG2, and the second source/drain trench ST2 may be formed between the second and third dummy gates DG2 and DG3.

Furthermore, a first sacrificial pattern trench 103T may be formed below the first source/drain trench ST1, and a second sacrificial pattern trench 104T may be formed below the second source/drain trench ST2. Each of the first and second sacrificial pattern trenches 103T and 104T may be formed in the active pattern 11 and the substrate 10. The substrate 10 may be exposed at the bottoms of the first and second sacrificial pattern trenches 103T and 104T.

During the formation of the first and second source/drain trenches ST1 and ST2, parts of the spacer material layer SM of FIGS. 7 and 8 on the upper surfaces of the first, second, and third dummy capping patterns DC1, DC2, and DC3 and parts of the first, second, and third dummy capping patterns DC1, DC2, and DC3 may be removed. Parts of the spacer material layer SM that remain on the sidewalls of each of the first, second, and third dummy gates DG1, DG2, and DG3 and on the sidewalls of each of the first, second, and third dummy capping patterns DC1, DC2, and DC3 may be defined as first gate spacers 111, second gate spacers 112, and third gate spacers 113.

For example, after the formation of the first and second source/drain trenches ST1 and ST2, parts of the second semiconductor layers 22 of FIGS. 7 and 8 that remain below the first dummy gate DG1 on the active pattern 11 may be defined as a first plurality of nanosheets NW1. Similarly, after the formation of the first and second source/drain trenches ST1 and ST2, parts of the second semiconductor layer 22 that remain below the second dummy gate DG2 on the active pattern 11 may be defined as a second plurality of nanosheets NW2, and parts of the second semiconductor layer 22 that remain below the third dummy gate DG3 on the active pattern 11 may be defined as a third plurality of nanosheets NW3.

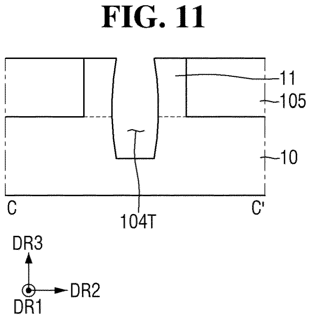

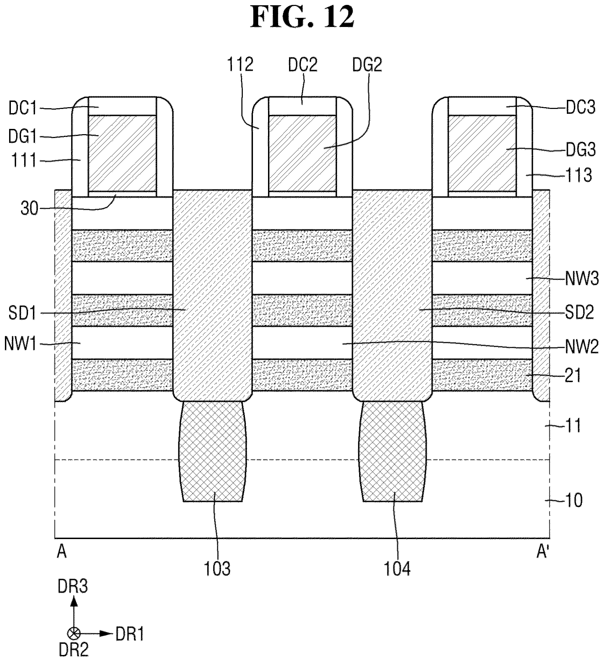

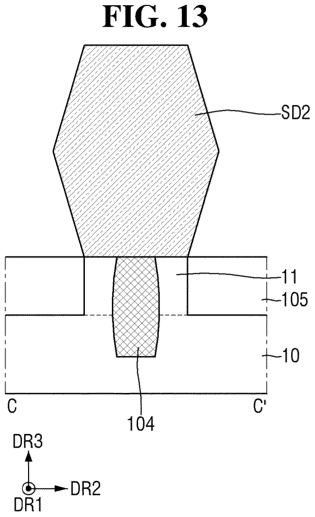

Referring to FIGS. 12 and 13, a first sacrificial pattern 103 may be formed in the first sacrificial pattern trench 103T of FIG. 9, and a second sacrificial pattern 104 may be formed in the second sacrificial pattern trench 104T of FIGS. 9 and 11. For example, the upper surfaces of the first and second sacrificial patterns 103 and 104 may be formed lower than the bottom surface of the lowermost first semiconductor layer 21. The first and second sacrificial patterns 103 and 104 may include, for example, SiGe. Alternatively, in some example embodiments, the first and second sacrificial patterns 103 and 104 may also include a low-k material.

Thereafter, a first source/drain region SD1 may be formed in the first source/drain trench ST1 of FIG. 9, and a second source/drain region SD2 may be formed in the second source/drain trench ST2 of FIG. 9. For example, the bottom surface of the first source/drain region SD1 may contact the upper surface of the first sacrificial pattern 103. Similarly, the bottom surface of the second source/drain region SD2 may contact the upper surface of the second sacrificial pattern 104.

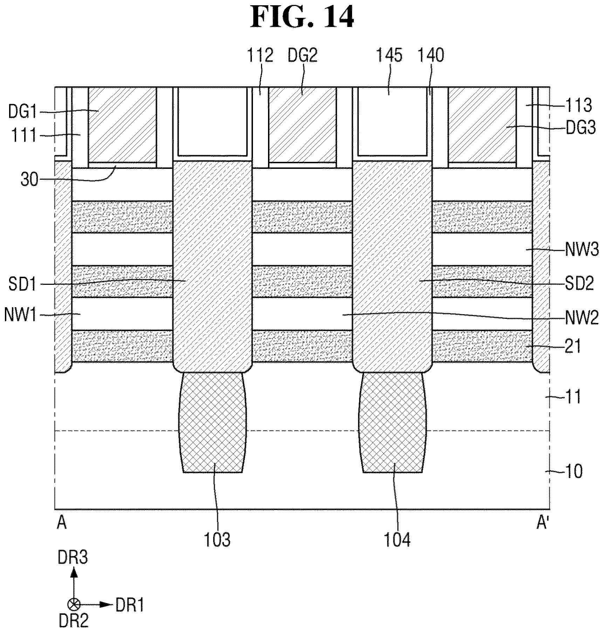

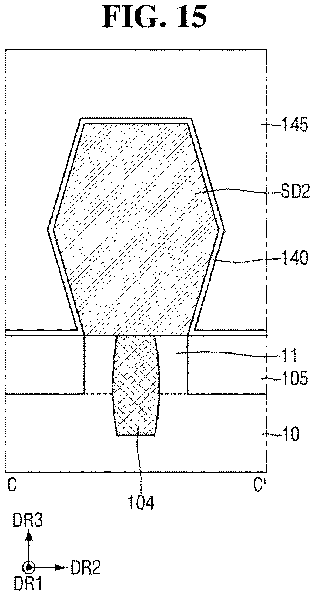

Referring to FIGS. 14 and 15, a first etch stopping layer 140 may be formed on the exposed upper surface of the field insulating layer 105, the exposed sidewalls of each of the first, second, and third gate spacers 111, 112, and 113, the exposed upper surfaces of the first, second, and third dummy capping patterns DC1, DC2, and DC3 of FIG. 12, and the exposed surfaces of the first and second source/drain regions SD1 and SD2. Thereafter, a first upper interlayer insulating layer 145 may be formed on the first etch stopping layer 140. Thereafter, the upper surfaces of the first, second, and third dummy gates DG1, DG2, and DG3 may be exposed through a planarization process.

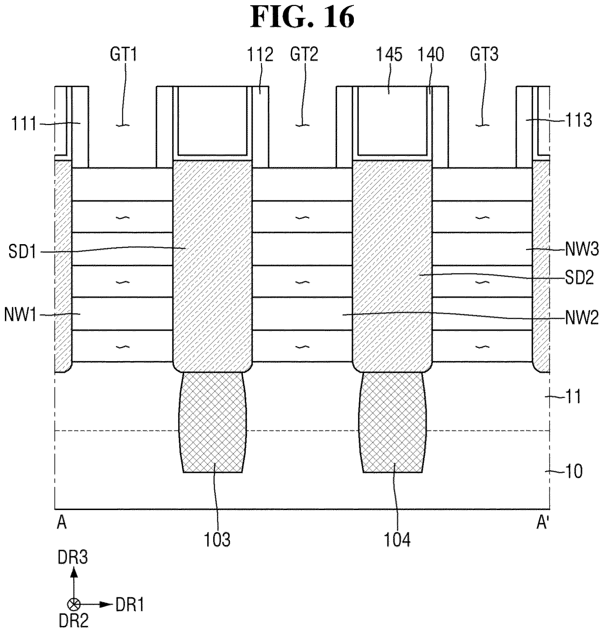

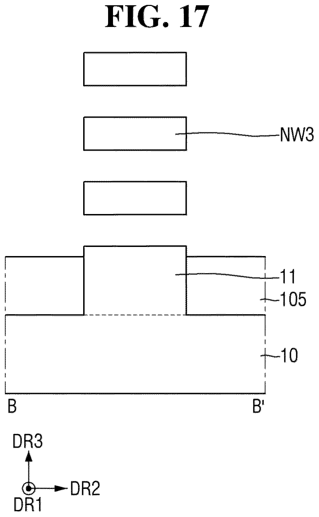

Referring to FIGS. 16 and 17, the first, second, and third dummy gates DG1, DG2, and DG3 of FIG. 14, the pad oxide layer 30 of FIG. 14, and the first semiconductor layers 21 of FIG. 14 may be etched. Parts of the first dummy gate DG1, the pad oxide layer 30, and the first semiconductor layers 21 of FIG. 14 that are etched may be defined as a first gate trench GT1. Similarly, parts of the second dummy gate DG2, the pad oxide layer 30, and the first semiconductor layers 21 of FIG. 14 that are etched may be defined as a second gate trench GT2. Parts of the third dummy gate DG3, the pad oxide layer 30, and the first semiconductor layers 21 of FIG. 14 that are etched may be defined as a third gate trench GT3.

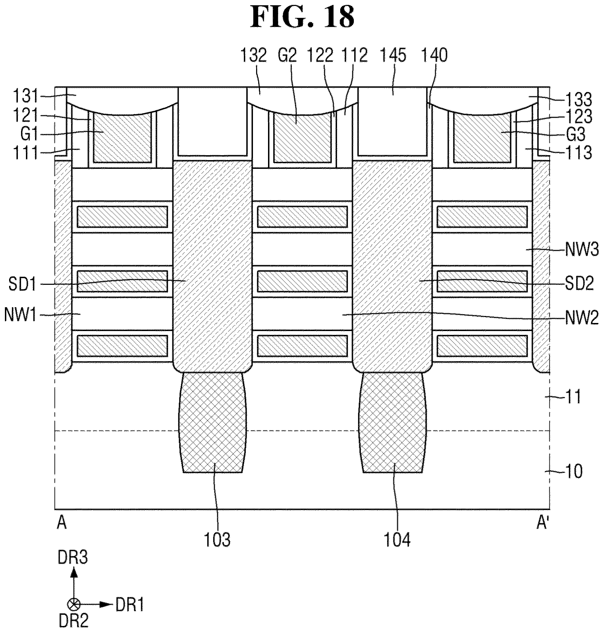

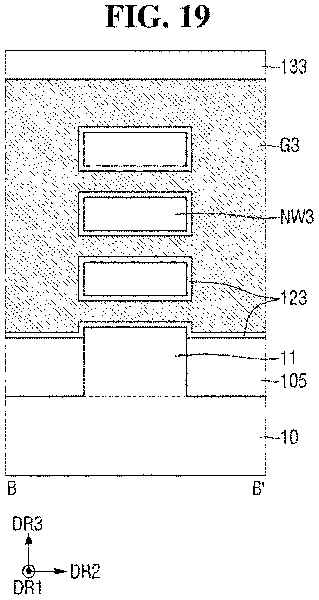

Referring to FIGS. 18 and 19, in the first gate trench GT1, a first gate insulating layer 121, a first gate electrode G1, and a first capping pattern 131 may be sequentially formed. Similarly, in the second gate trench GT2, a second gate insulating layer 122, a second gate electrode G2, and a second capping pattern 132 may be sequentially formed. Additionally, in the third gate trench GT3, a third gate insulating layer 123, a third gate electrode G3, and a third capping pattern 133 may be sequentially formed.

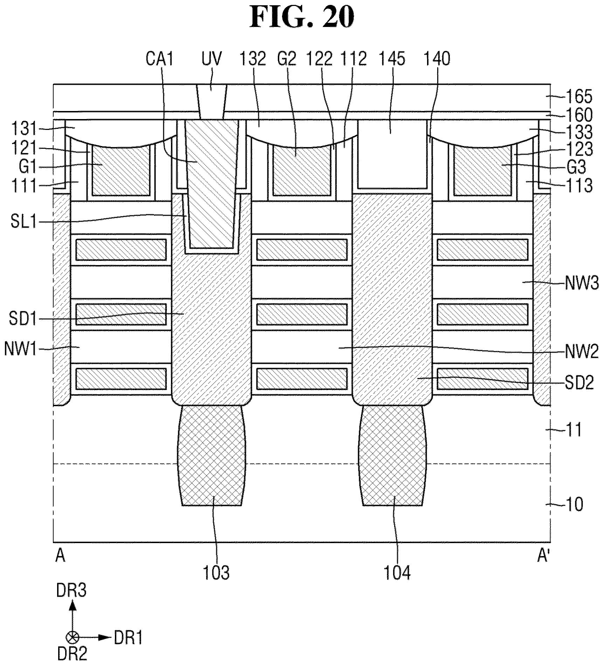

Referring to FIGS. 20 through 22, the first source/drain contact CA1 may be formed on the first source/drain region SD1. The first source/drain contact CA1 may extend into the interior of the first source/drain region SD1 by penetrating the first upper interlayer insulating layer 145 and the first etch stopping layer 140 in the vertical direction DR3. Also, a first silicide layer SL1 may be formed between the first source/drain region SD1 and the first source/drain contact CA1.

Thereafter, a second etch stopping layer 160 and a second upper interlayer insulating layer 165 may be sequentially formed on the upper surfaces of the first upper interlayer insulating layer 145, the first, second, and third capping patterns 131, 132, and 133, and the first source/drain contact CA1. Thereafter, an upper via UV, which is connected to the first source/drain contact CA1 by penetrating the second etch stopping layer 160 and the second upper interlayer insulating layer 165 in the vertical direction DR3, may be formed.

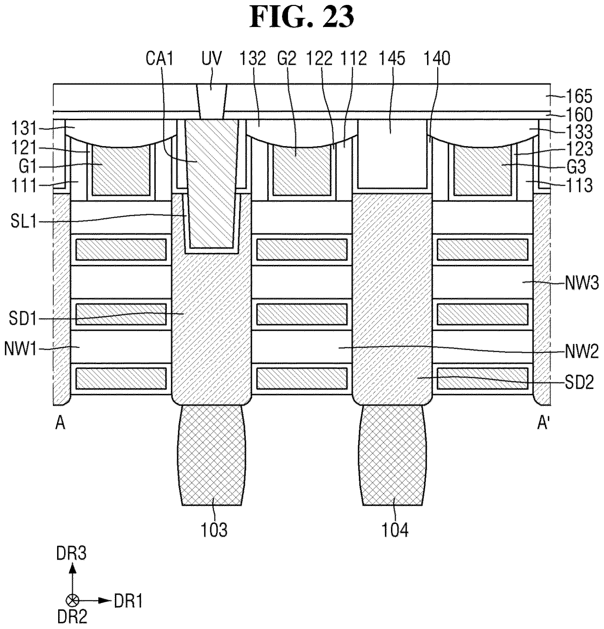

Referring to FIGS. 23 through 25, the substrate 10 and the active pattern 11 of FIGS. 20 through 22 may be etched. As a result, parts of the first, second, and third gate insulating layers 121, 122, and 123, parts of the first and second source/drain regions SD1 and SD2, part of the field insulating layer 105, and parts of the first and second sacrificial patterns 103 and 104 may be exposed.

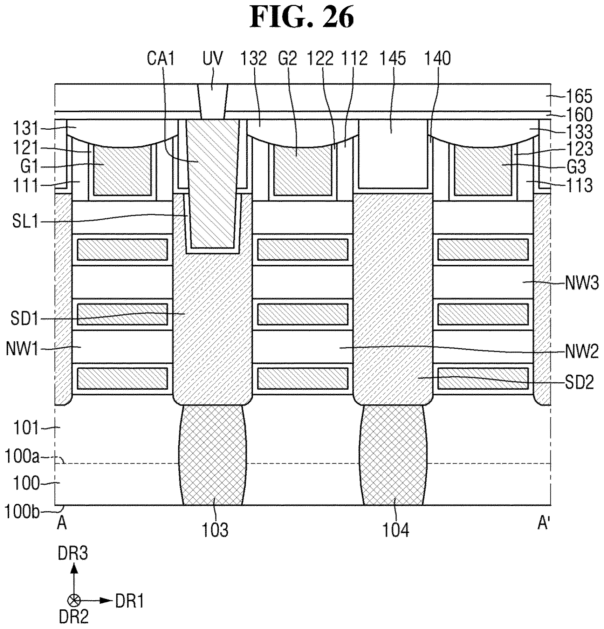

Referring to FIGS. 26 through 28, a first lower interlayer insulating layer 100 and an insulating pattern 101 may be formed in parts where the substrate 10 of FIGS. 20 through 22 and the active pattern 11 of FIGS. 20 through 22 have been etched. For example, the insulating pattern 101 may be formed in the part where the active pattern 11 of FIGS. 20 through 22 has been etched away. The insulating pattern 101 may contact the first, second, and third gate insulating layers 121, 122, and 123, the first and second source/drain regions SD1 and SD2, the field insulating layer 105, and the first and second sacrificial patterns 103 and 104. The insulating pattern 101 may surround parts of the sidewalls of each of the first and second sacrificial patterns 103 and 104.

Additionally, the first lower interlayer insulating layer 100 may be formed in the part of the substrate 10 of FIGS. 20 through 22 that has been etched. The first lower interlayer insulating layer 100 may contact the field insulating layer 105 and the first and second sacrificial patterns 103 and 104. The first lower interlayer insulating layer 100 may surround parts of the sidewalls of each of the first and second sacrificial patterns 103 and 104 that remain. For example, the bottom surfaces of the first and second sacrificial patterns 103 and 104 may be exposed on a bottom surface 100b of the first lower interlayer insulating layer 100. That is, the bottom surfaces of the first and second sacrificial patterns 103 and 104 may be formed on the same plane as the bottom surface 100b of the first lower interlayer insulating layer 100.

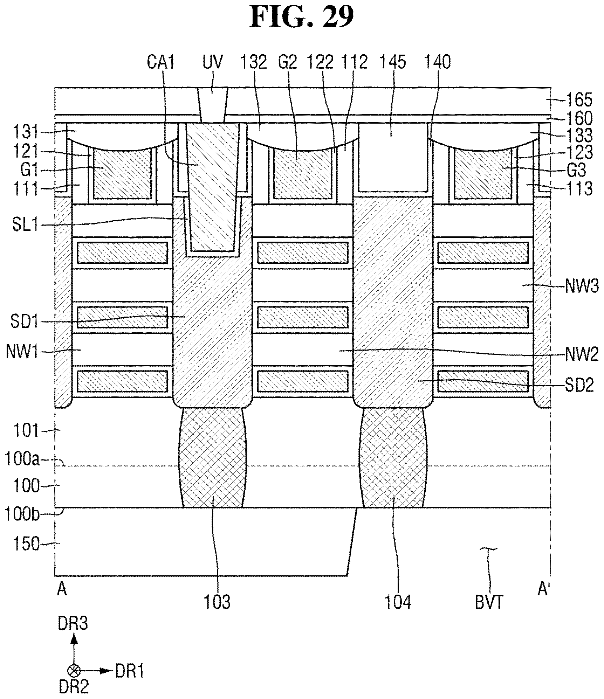

Referring to FIGS. 29 through 31, a second lower interlayer insulating layer 150 may be formed on the bottom surface 100b of the first lower interlayer insulating layer 100 and the bottom surfaces of the first and second sacrificial patterns 103 and 104. Thereafter, a bottom via trench BVT may be formed in the second lower interlayer insulating layer 150. For example, the bottom via trench BVT may be formed below the second sacrificial pattern 104 and the third gate electrode G3. The bottom via trench BVT may expose both the bottom surface 100b of the first lower interlayer insulating layer 100 and the bottom surface of the second sacrificial pattern 104.

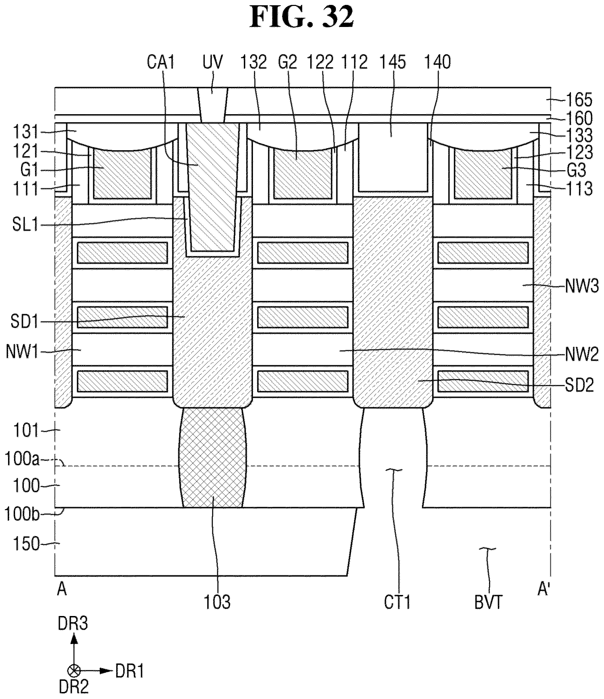

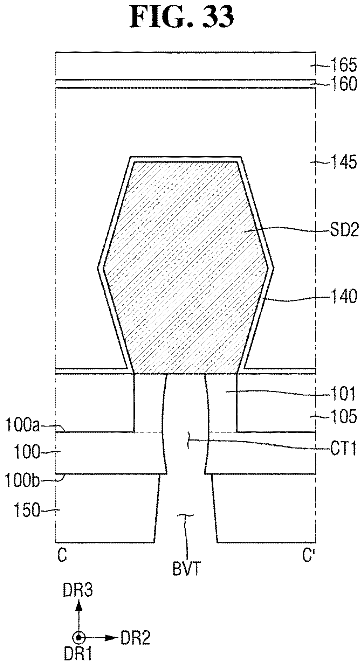

Referring to FIGS. 32 and 33, the second sacrificial pattern 104 of FIG. 29, exposed by the bottom via trench BVT, may be etched away. The part where the second sacrificial pattern 104 has been etched away may be defined as a first contact trench CT1. In other words, the first contact trench CT1 may be formed on the bottom via trench BVT. The first contact trench CT1 may expose the bottom surface of the second source/drain region SD2.

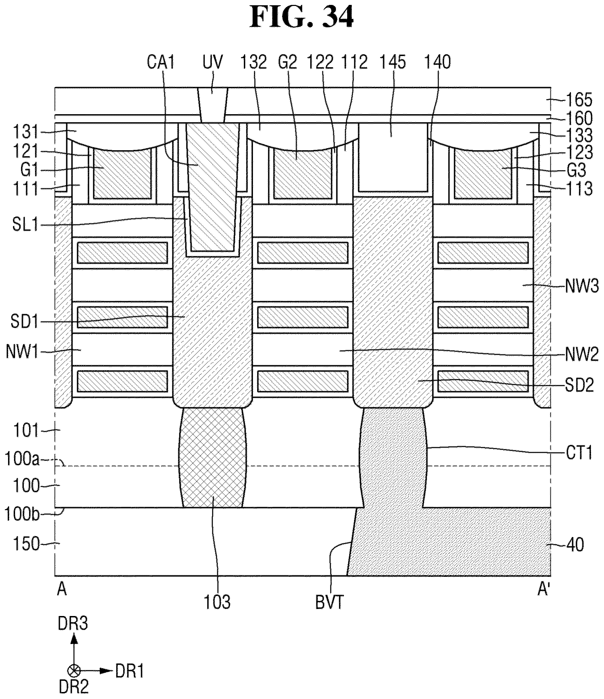

Referring to FIGS. 34 through 36, a third sacrificial pattern 40 may be formed in each of the bottom via trench BVT and the first contact trench CT1. For example, the third sacrificial pattern 40 may completely fill both the bottom via trench BVT and the first contact trench CT1. The third sacrificial pattern 40 may include a material different from a material of each of the insulating pattern 101, the first lower interlayer insulating layer 100, and the second lower interlayer insulating layer 150. For example, the third sacrificial pattern 40 may include a spin-on-hardmask (SOH). Alternatively, in some example embodiments, the third sacrificial pattern 40 may also include an insulating material different from an insulating material of each of the insulating pattern 101, the first lower interlayer insulating layer 100, and the second lower interlayer insulating layer 150.

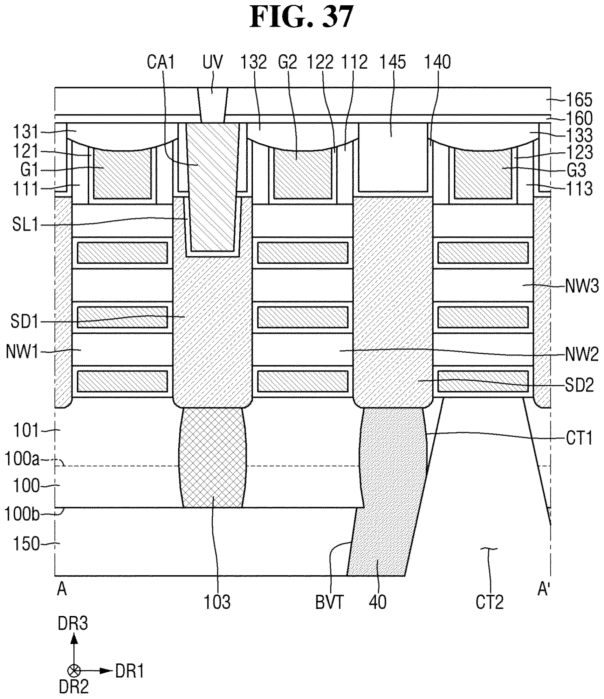

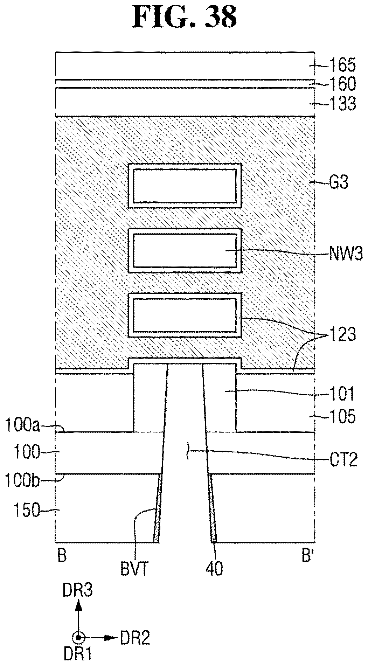

Referring to FIGS. 37 and 38, a second contact trench CT2 may be formed below the third gate electrode G3. The second contact trench CT2 may extend to the third gate insulating layer 123 by penetrating the third sacrificial pattern 40, the first lower interlayer insulating layer 100, and the insulating pattern 101 in the vertical direction DR3. For example, the third gate insulating layer 123 may be exposed by the second contact trench CT2. Parts of the sidewalls of the third sacrificial pattern 40 in the first lower interlayer insulating layer 100 may be exposed by the second contact trench CT2.

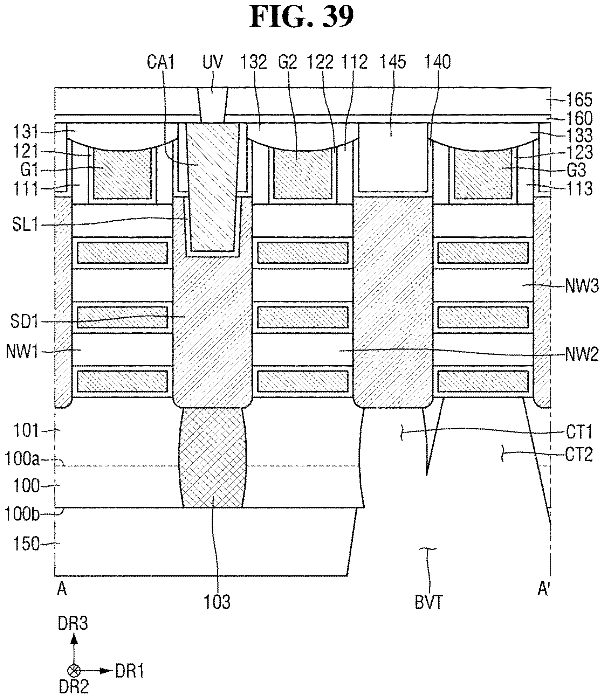

Referring to FIGS. 39 through 41, the third sacrificial pattern 40 may be etched. As a result, the first contact trench CT1, the second contact trench CT2, and the bottom via trench BCT may be connected.

Referring to FIGS. 2 through 4, through the same process, a conductive material layer may be formed in the first contact trench CT1, the second contact trench CT2, and the bottom via trench BCT of FIGS. 39 through 41. For example, part of the conductive material layer formed in the first contact trench CT1 of FIGS. 39 through 41 may be defined as a second source/drain contact CA2, part of the conductive material layer formed in the second contact trench CT2 of FIGS. 39 through 41 may be defined as a gate contact CB, and part of the conductive material layer formed in the bottom via trench BCT of FIGS. 39 through 41 may be defined as a bottom via BV.

As a result, the second source/drain contact CA2, the gate contact CB, and the bottom via BV may include the same material. Furthermore, the second source/drain contact CA2, the gate contact CB, and the bottom via BV may contact one another. That is, the second source/drain contact CA2, the gate contact CB, and the bottom via BV may be integrally formed. In this manner, the semiconductor device of FIGS. 2 through 4 can be fabricated.

The second source/drain contact CA2 may be disposed below the second source/drain region SD2, the gate contact CB may be disposed below the third gate electrode G3, and the bottom via BV may be disposed below both the second source/drain region SD2 and the gate contact CB. The second source/drain contact CA2, the gate contact CB, and the bottom via BV may be arranged to contact one another. In other words, the second source/drain contact CA2, the gate contact CB, and the bottom via BV may be integrally formed. As a result, a process margin for forming the second source/drain contact CA2, the gate contact CB, and the bottom via BV can be secured.

Additionally, the second source/drain contact CA2, the gate contact CB, and the bottom via BV may be formed by the same process. Consequently, the formation of the second source/drain contact CA2, the gate contact CB, and the bottom via BV can be simplified.

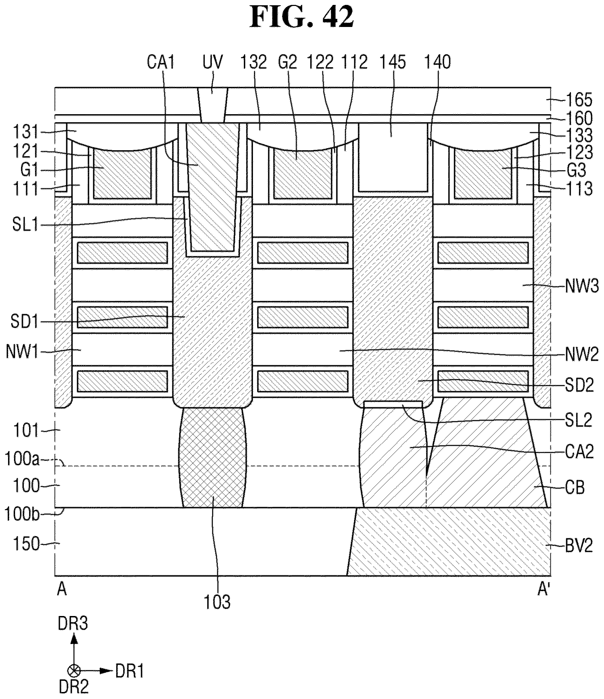

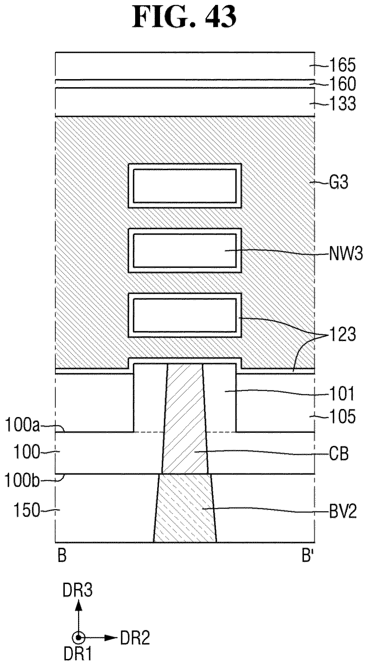

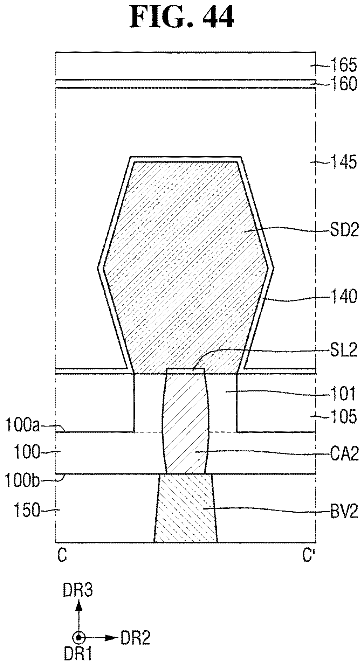

A semiconductor device according to other example embodiments of the inventive concepts will hereinafter be described with reference to FIGS. 42 through 44, focusing mainly on the differences from the semiconductor device of FIGS. 1 through 4.

FIGS. 42 through 44 are cross-sectional views for explaining a semiconductor device according to some example embodiments of the inventive concepts.

Referring to FIGS. 42 through 44, a bottom via BV2 is not integrally formed with a second source/drain contact CA2 and a gate contact CB.

For example, after the formation of the second source/drain contact CA2 and the gate contact CB, the bottom via BV2 may be formed through a subsequent process. As a result, a boundary surface may be formed between the bottom via BV2 and the second source/drain contact CA2. A boundary surface may also be formed between the bottom via BV2 and the gate contact CB. For example, the bottom via BV2 may include the same material as both the second source/drain contact CA2 and the gate contact CB, but example embodiments are not limited thereto. Alternatively, in some example embodiments, the bottom via BV2 may include a material different from a material of each of the second source/drain contact CA2 and the gate contact CB.

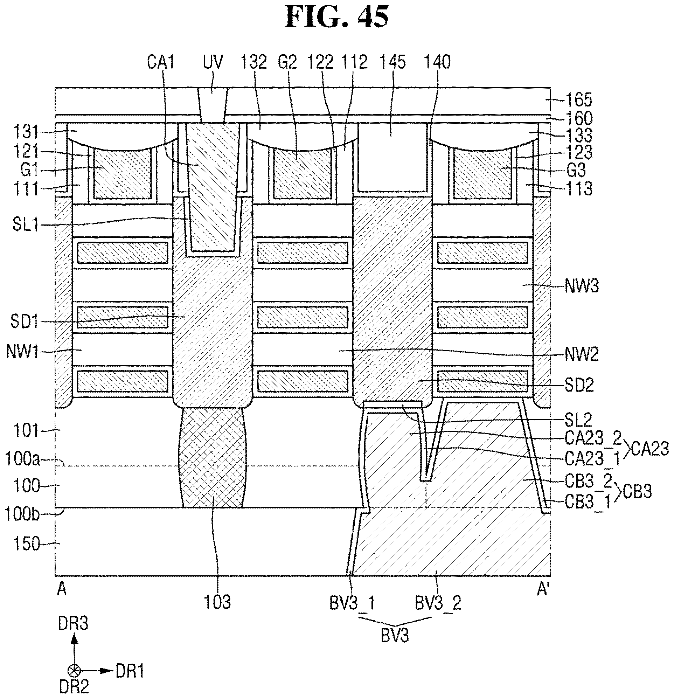

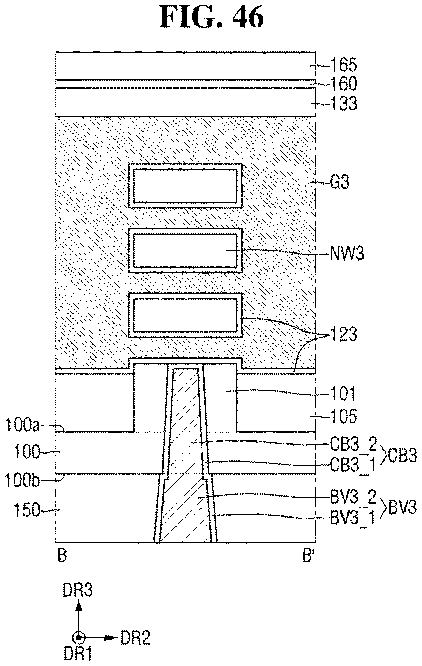

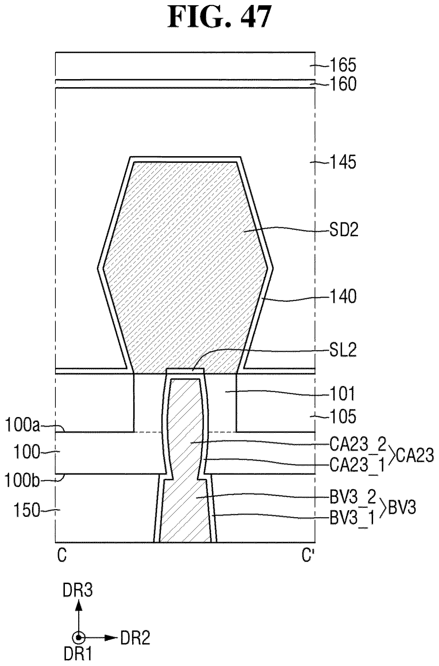

A semiconductor device according to other example embodiments will hereinafter be described with reference to FIGS. 45 through 47, focusing mainly on the differences from the semiconductor device of FIGS. 1 through 4.

FIGS. 45 through 47 are cross-sectional views for explaining a semiconductor device according to some example embodiments of the inventive concepts.

Referring to FIGS. 45 through 47, a second source/drain contact CA23, a gate contact BC3, and a bottom via BV3 may be formed as double films.

For example, the second source/drain contact CA23 may include a first contact barrier layer CA23_1 and a first contact filling layer CA23_2. The first contact barrier layer CA23_1 may form the sidewalls and upper surface of the second source/drain contact CA23. For example, the first contact barrier layer CA23_1 may be conformally formed on the first contact filling layer CA23_2. The first contact filling layer CA23_2 may fill the space between parts of the first contact barrier layer CA23_1.

A gate contact CB3 may include a second contact barrier layer CB3_1 and a second contact filling layer CB3_2. The second contact barrier layer CB3_1 may form the sidewalls and upper surface of the gate contact CB3. For example, the second contact barrier layer CB3_1 may be conformally formed on the second contact filling layer CA23_2. The second contact filling layer CB3_2 may fill the space between parts of the second contact barrier layer CB3_1.

The bottom via BV3 may include a bottom via barrier layer BV3_1 and a bottom via filling layer BV3_2. The bottom via barrier layer BV3_1 may form the sidewalls and upper surface of the bottom via BV3. For example, the bottom via barrier layer BV3_1 may be conformally formed on the bottom via BV3. The bottom via filling layer BV3_2 may fill the space between parts of the bottom via barrier layer BV3_1.

For example, the first contact barrier layer CA23_1, the second contact barrier layer CB3_1, and the bottom via barrier layer BV3_1 may be continuously formed. The first contact barrier layer CA23_1, the second contact barrier layer CB3_1, and the bottom via barrier layer BV3_1 may be integrally formed. The first contact barrier layer CA23_1, the second contact barrier layer CB3_1, and the bottom via barrier layer BV3_1 may include the same material. For example, the first contact barrier layer CA23_1, the second contact barrier layer CB3_1, and the bottom via barrier layer BV3_1 may include one of Ta, TaN, Ti, TiN, Ru, Co, Ni, nickel boron (NiB), W, WN, tungsten carbonitride (WCN), Zr, zirconium nitride (ZrN), V, vanadium nitride (VN), Nb, NbN, Pt, Ir, and Rh. However, example embodiments are not limited thereto.

For example, the first contact filling layer CA23_2, the second contact filling layer CB3_2, and the bottom via filling layer BV3_2 may be integrally formed. At least parts of the sidewalls of the second contact filling layer CB3_2 may contact the first contact filling layer CA23_2. Additionally, the bottom surfaces of both the first contact filling layer CA23_2 and the second contact filling layer CB3_2 may contact the upper surface of the bottom via filling layer BV3_2. The first contact filling layer CA23_2, the second contact filling layer CB3_2, and the bottom via filling layer BV3_2 may include the same material. For example, the first contact filling layer CA23_2, the second contact filling layer CB3_2, and the bottom via filling layer BV3_2 may include one of Al, W, Co, Ru, and Mo. However, example embodiments are not limited thereto.

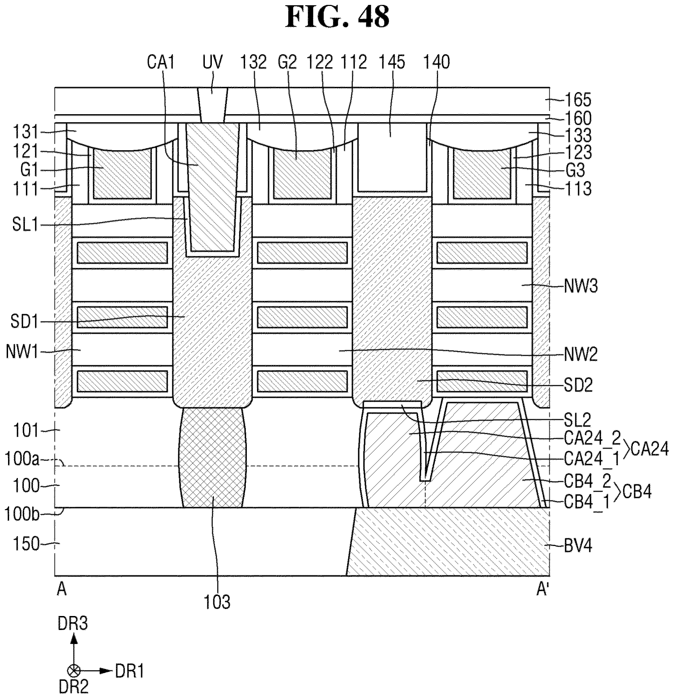

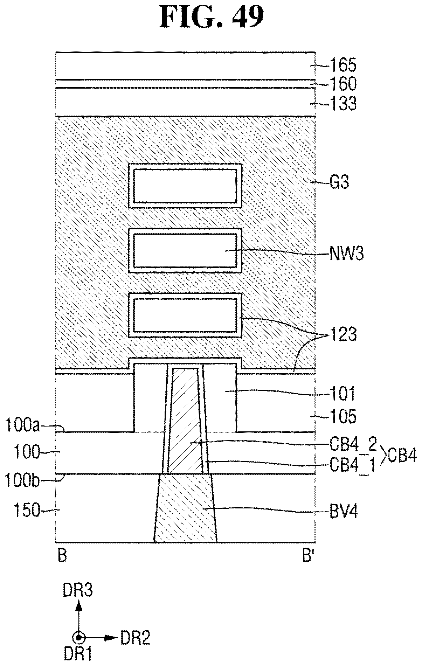

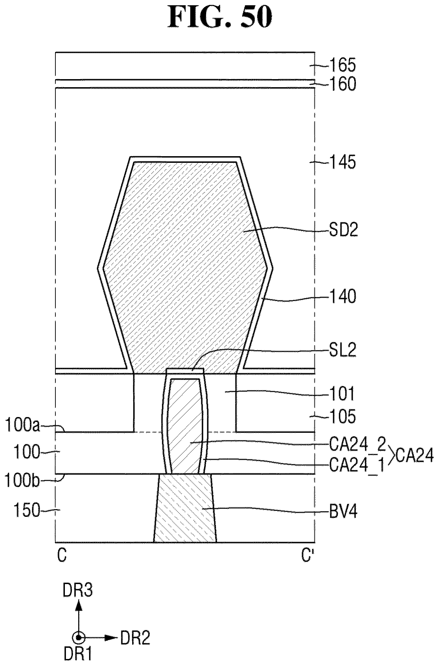

A semiconductor device according to other example embodiments of the inventive concepts will hereinafter be described with reference to FIGS. 48 through 50, focusing mainly on the differences from the semiconductor device of FIGS. 1 through 4.

FIGS. 48 through 50 are cross-sectional views for explaining a semiconductor device according to some example embodiments of the inventive concepts.

Referring to FIGS. 48 through 50, a second source/drain contact CA24 and a gate contact CB4 may be formed as double films.

For example, the second source/drain contact CA24 may include a first contact barrier layer CA24_1 and a first contact filling layer CA24_2. The first contact barrier layer CA24_1 may form the sidewalls and upper surface of the second source/drain contact CA24. For example, the first contact barrier layer CA24_1 may be conformally formed on the first contact filling layer CA24_2. The first contact filling layer CA24_2 may fill the space between parts of the first contact barrier layer CA24_1.

The gate contact CB4 may include a second contact barrier layer CB4_1 and a second contact filling layer CB4_2. The second contact barrier layer CB4_1 may form the sidewalls and upper surface of the gate contact CB4. For example, the second contact barrier layer CB4_1 may be conformally formed on the second contact filling layer CB24_2. The second contact filling layer CB4_2 may fill the space between parts of the second contact barrier layer CB4_1.

For example, the first contact barrier layer CA24_1 and the second contact barrier layer CB4_1 may be continuously formed. The first contact barrier layer CA24_1 and the second contact barrier layer CB4_1 may be integrally formed. The first contact barrier layer CA24_1 and the second contact barrier layer CB4_1 may include the same material. For example, the first contact barrier layer CA24_1, the second contact barrier layer CB4_1, and a bottom via barrier layer BV3_1 may include one of Ta, TaN, Ti, TiN, Ru, Co, Ni, NiB, W, WN, WCN, Zr, ZrN, V, VN, Nb, NbN, Pt, Ir, and Rh. However, example embodiments are not limited thereto.

For example, the first contact filling layer CA24_2 and the second contact filling layer CB4_2 may be integrally formed. At least parts of the sidewalls of the second contact filling layer CB4_2 may contact the first contact filling layer CA24_2. The first contact filling layer CA24_2 and the second contact filling layer CB4_2 may include the same material. For example, the first contact filling layer CA24_2 and the second contact filling layer CB4_2 may include one of Al, W, Co, Ru, and Mo. However, example embodiments are not limited thereto.

For example, a bottom via BV4 is not integrally formed with the second source/drain contact CA24 and the gate contact CB4. For example, after the formation of the second source/drain contact CA24 and the gate contact CB4, the bottom via BV4 may be formed through a subsequent process. As a result, a boundary surface may be formed between the bottom via BV4 and the second source/drain contact CA24. A boundary surface may also be formed between the bottom via BV4 and the gate contact CB4. The bottom via BV4 may include the same material as both the second source/drain contact CA24 and the gate contact CB4, but example embodiments are not limited thereto. Alternatively, in some example embodiments, the bottom via BV4 may include a material different from a material of each of the second source/drain contact CA24 and the gate contact CB4.

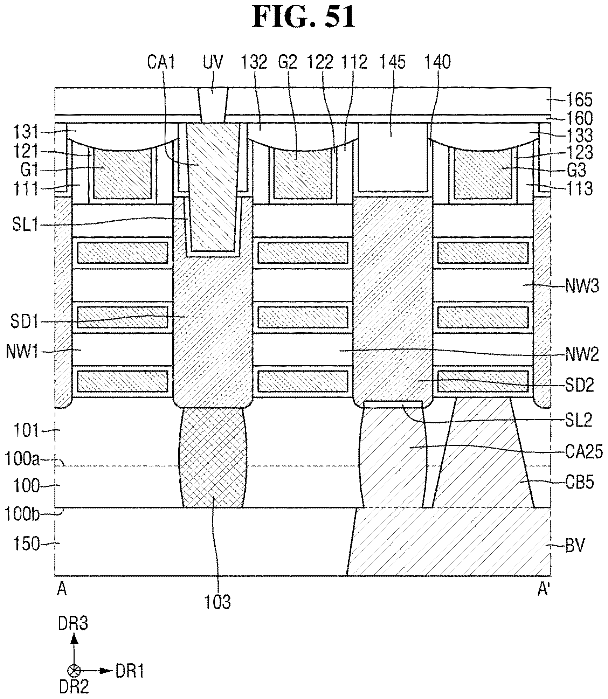

A semiconductor device according to other example embodiments of the inventive concepts will hereinafter be described with reference to FIG. 51, focusing mainly on the differences from the semiconductor device of FIGS. 1 through 4.

FIG. 51 is a cross-sectional view for explaining a semiconductor device according to some example embodiments of the inventive concepts.

Referring to FIG. 51, a gate contact CBS may be spaced apart from a second source/drain contact CA25 in a first horizontal direction DR1.

For example, the second source/drain contact CA25 and the gate contact CBS may be separated in the first horizontal direction DR1 by a first lower interlayer insulating layer 100 and an insulating pattern 101. For example, the second source/drain contact CA25, the gate contact CBS, and a bottom via BV may be integrally formed.

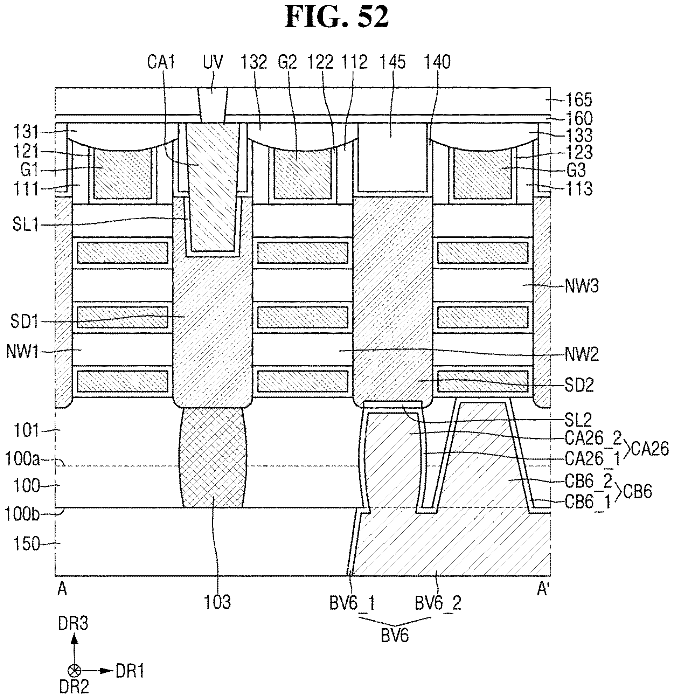

A semiconductor device according to other example embodiments of the inventive concepts will hereinafter be described with reference to FIG. 52, focusing mainly on the differences from the semiconductor device of FIGS. 1 through 4.

FIG. 52 is a cross-sectional view for explaining a semiconductor device according to some example embodiments of the inventive concepts.

Referring to FIG. 52, a gate contact CB6 may be spaced apart from a second source/drain contact CA26 in a first horizontal direction DR1. Additionally, the second source/drain contact CA26, the gate contact CB6, and a bottom via BV6 may be formed as double films.

For example, the second source/drain contact CA26 and the gate contact CB6 may be separated in the first horizontal direction DR1 by a first lower interlayer insulating layer 100 and an insulating pattern 101. For example, the second source/drain contact CA26 may include a first contact barrier layer CA26_1 and a first contact filling layer CA26_2. The first contact barrier layer CA26_1 may form the sidewalls and upper surface of the second source/drain contact CA26. The first contact barrier layer CA26_1 may be conformally formed. The first contact filling layer CA26_2 may fill the space between parts of the first contact barrier layer CA26_1.

The gate contact CB6 may include a second contact barrier layer CB6_1 and a second contact filling layer CB6_2. The second contact barrier layer CB6_1 may form the sidewalls and upper surface of the gate contact CB6. For example, the second contact barrier layer CB6_1 may be conformally formed. The second contact filling layer CB6_2 may fill the space between parts of the second contact barrier layer CB6_1.

A bottom via BV6 may include a bottom via barrier layer BV6_1 and a bottom via filling layer BV6_2. The bottom via barrier layer BV6_1 may form the sidewalls and upper surface of the bottom via BV6. For example, the bottom via barrier layer BV6_1 may be conformally formed. The bottom via filling layer BV6_2 may fill the space between parts of the bottom via barrier layer BV6_1.

For example, the first contact barrier layer CA26_1, the second contact barrier layer CB6_1, and the bottom via barrier layer BV6_1 may be continuously formed. The first contact barrier layer CA26_1, the second contact barrier layer CB6_1, and the bottom via barrier layer BV6_1 may be integrally formed. The first contact barrier layer CA26_1, the second contact barrier layer CB6_1, and the bottom via barrier layer BV6_1 may include the same material. For example, the first contact barrier layer CA26_1, the second contact barrier layer CB6_1, and the bottom via barrier layer BV6_1 may include one of Ta, TaN, Ti, TiN, Ru, Co, Ni, NiB, W, WN, WCN, Zr, ZrN, V, VN, Nb, NbN, Pt, Ir, and Rh. However, example embodiments are not limited thereto.

The barrier layers, e.g. CA26_1, CB6_1, BV6_1, may be formed of a different material to the filling layers, e.g. CB6_2, CA26_2, BV6_2.

For example, the first contact filling layer CA26_2, the second contact filling layer CB6_2, and the bottom via filling layer BV6_2 may be integrally formed. At least parts of the sidewalls of the second contact filling layer CB6_2 may contact the first contact filling layer CA26_2. Additionally, the bottom surfaces of both the first contact filling layer CA26_2 and the second contact filling layer CB6_2 may contact the upper surface of the bottom via filling layer BV6_2. The first contact filling layer CA26_2, the second contact filling layer CB6_2, and the bottom via filling layer BV6_2 may include the same material. For example, the first contact filling layer CA26_2, the second contact filling layer CB6_2, and the bottom via filling layer BV6_2 may include one of Al, W, Co, Ru, and Mo. However, example embodiments are not limited thereto.

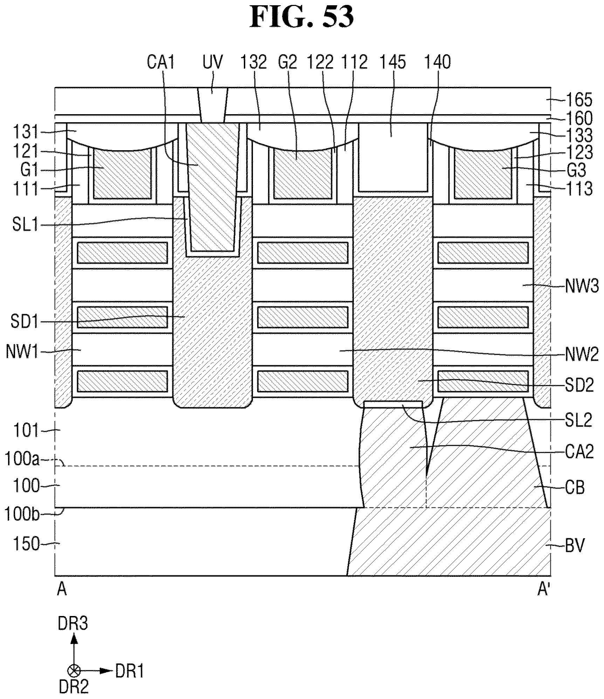

A semiconductor device according to other example embodiments of the inventive concepts will hereinafter be described with reference to FIG. 53, focusing mainly on the differences from the semiconductor device of FIGS. 1 through 4.

FIG. 53 is a cross-sectional view for explaining a semiconductor device according to some example embodiments of the inventive concepts.

Referring to FIG. 53, no first sacrificial pattern ("103" of FIG. 2) is not disposed below a first source/drain region SD1. For example, the bottom surface of the first source/drain region SD1 may generally contact an insulating pattern 101.

While various example embodiments have been described with reference to the attached drawings, it should be understood that the inventive concepts are not limited to these example embodiments. Various example embodiments can be manufactured in various different forms, and those of ordinary skill in the art will appreciate that the example embodiments can be carried out in other specific forms without changing the essential features of the inventive concepts. Therefore, the example embodiments described above should be considered in all respects as illustrative and not restrictive.

### ANNEX A

The present invention can also be defined by reference to the following clauses:
Clause 1. A semiconductor device comprising:
   a first lower interlayer insulating layer;
   an insulating pattern extending in a first horizontal direction on an upper surface of the first lower interlayer insulating layer;
   a plurality of nanosheets stacked apart from one another in a vertical direction on the insulating pattern;
   a gate electrode extending in a second horizontal direction different from the first horizontal direction on the insulating pattern, the gate electrode surrounding the plurality of nanosheets;
   a source/drain region on at least one side of the gate electrode on the insulating pattern;
   a source/drain contact penetrating the first lower interlayer insulating layer and the insulating pattern in the vertical direction, the source/drain contact electrically connected to the source/drain region;
   a gate contact penetrating the first lower interlayer insulating layer and the insulating pattern in the vertical direction, the gate contact electrically connected to the gate electrode;
   a second lower interlayer insulating layer on a bottom surface of the first lower interlayer insulating layer; and
   a bottom via in the second lower interlayer insulating layer, the bottom via contacting each of a bottom surface of the source/drain contact and a bottom surface of the gate contact,
   wherein the bottom via is integrally formed with each of the source/drain contact and the gate contact.
Clause 2. The semiconductor device of clause 1, wherein at least part of the insulating pattern is between the source/drain contact and the gate contact.
Clause 3. The semiconductor device of clause 1 or clause 2, wherein the gate contact is spaced apart from the source/drain contact in the first horizontal direction.
Clause 4. The semiconductor device of any of clauses 1 to 3, wherein each of the bottom via, the source/drain contact and the gate contact is a single film.
Clause 5. The semiconductor device of any of clauses 1 to 4, wherein the source/drain contact includes a first contact barrier layer forming sidewalls and an upper surface of the source/drain contact, and a first contact filling layer filling a space between parts of the first contact barrier layer,
   wherein the gate contact includes a second contact barrier layer forming sidewalls and an upper surface of the gate contact, and a second contact filling layer filling a space between a portion of the second contact barrier layer,
   wherein the bottom via includes a bottom via barrier layer forming sidewalls of the bottom via, and a bottom via filling layer filling a space between a portion of the bottom via barrier layer, and
   wherein the bottom via filling layer contacts each of the first and second contact filling layers.

## Claims

1. A semiconductor device comprising:
a first lower interlayer insulating layer;
an insulating pattern extending in a first horizontal direction on an upper surface of the first lower interlayer insulating layer;
a first plurality of nanosheets stacked apart from one another in a vertical direction on the insulating pattern;
a second plurality of nanosheets stacked apart from one another in the vertical direction on the insulating pattern, the second plurality of nanosheets spaced apart from the first plurality of nanosheets in the first horizontal direction;
a first gate electrode extending in a second horizontal direction different from the first horizontal direction on the insulating pattern, the first gate electrode surrounding the first plurality of nanosheets;
a second gate electrode extending in the second horizontal direction on the insulating pattern, the second gate electrode surrounding the second plurality of nanosheets, the second gate electrode spaced apart from the first gate electrode in the first horizontal direction;
a source/drain region between the first and second gate electrodes on the insulating pattern;
a source/drain contact penetrating the first lower interlayer insulating layer and the insulating pattern in the vertical direction, the source/drain contact electrically connected to the source/drain region; and
a gate contact penetrating the first lower interlayer insulating layer and the insulating pattern in the vertical direction, the gate contact electrically connected to the second gate electrode, at least a portion of a sidewall of the gate contact contacting the source/drain contact,
wherein the source/drain contact and the gate contact are integrally formed.

2. The semiconductor device of claim 1, wherein bottom surfaces of the source/drain contact and the gate contact are on the same plane.

3. The semiconductor device of claim 1 or claim 2, further comprising:
a gate insulating layer between the second gate electrode and the second plurality of nanosheets and between the second gate electrode and the gate contact,
wherein the gate insulating layer contacts the gate contact.

4. The semiconductor device of any preceding claim, wherein at least part of the insulating pattern is between the source/drain contact and the gate contact.

5. The semiconductor device of any preceding claim, further comprising:
a second lower interlayer insulating layer on a bottom surface of the first lower interlayer insulating layer; and
a bottom via in the second lower interlayer insulating layer, the bottom via contacting each of a bottom surface of the source/drain contact and a bottom surface of the gate contact.

6. The semiconductor device of claim 5, wherein the bottom via is integrally formed with each of the source/drain contact and the gate contact.

7. The semiconductor device of any preceding claim, wherein an upper surface of the source/drain contact is lower than a bottom surface of a lowermost nanosheet of the second plurality of nanosheets.

8. The semiconductor device of any preceding claim, wherein an upper surface of the gate contact is higher than an upper surface of the source/drain contact.

9. The semiconductor device of any preceding claim, wherein each of the source/drain contact and the gate contact is a single film.

10. The semiconductor device of any preceding claim, wherein the source/drain contact includes a first contact barrier layer forming sidewalls and an upper surface of the source/drain contact, and a first contact filling layer filling a space between parts of the first contact barrier layer,
wherein the gate contact includes a second contact barrier layer forming sidewalls and an upper surface of the gate contact, and a second contact filling layer filling a space between a portion of the second contact barrier layer, and
wherein the first contact filling layer contacts the second contact filling layer.

11. A semiconductor device as claimed in any preceding claim,
wherein the source/drain region is on at least one side of the second gate electrode on the insulating pattern, wherein the semiconductor device comprises:
a second lower interlayer insulating layer on a bottom surface of the first lower interlayer insulating layer; and
a bottom via in the second lower interlayer insulating layer, the bottom via contacting each of a bottom surface of the source/drain contact and a bottom surface of the gate contact,
wherein the bottom via is integrally formed with each of the source/drain contact and the gate contact.

12. The semiconductor device of claim 11, wherein at least part of the insulating pattern is between the source/drain contact and the gate contact.

13. The semiconductor device of claim 11 or claim 12, wherein the gate contact is spaced apart from the source/drain contact in the first horizontal direction.

14. The semiconductor device of any of claims 11 to 13, wherein each of the bottom via, the source/drain contact and the gate contact is a single film.

15. The semiconductor device of any of claims 11 to 14, wherein the source/drain contact includes a first contact barrier layer forming sidewalls and an upper surface of the source/drain contact, and a first contact filling layer filling a space between parts of the first contact barrier layer,
wherein the gate contact includes a second contact barrier layer forming sidewalls and an upper surface of the gate contact, and a second contact filling layer filling a space between a portion of the second contact barrier layer,
wherein the bottom via includes a bottom via barrier layer forming sidewalls of the bottom via, and a bottom via filling layer filling a space between a portion of the bottom via barrier layer, and
wherein the bottom via filling layer contacts each of the first and second contact filling layers.
